(19) Europäisches Patentamt
European Patent Office
Office européen des brevets

(11) EP 1 589 789 B1

(12) **EUROPEAN PATENT SPECIFICATION**

(45) Date of publication and mention of the grant of the patent:
**01.07.2015 Bulletin 2015/27**

(21) Application number: **04702427.8**

(22) Date of filing: **15.01.2004**

(51) Int Cl.:
***C09K 11/06*** *(2006.01)* ***H05B 33/22*** *(2006.01)*
***H05B 33/14*** *(2006.01)* ***H01L 51/00*** *(2006.01)*
***H01L 51/50*** *(2006.01)*

(86) International application number:
**PCT/JP2004/000236**

(87) International publication number:
**WO 2004/066685 (05.08.2004 Gazette 2004/32)**

# (54) ORGANIC ELECTROLUMINESCENCE DEVICE

ORGANISCHE ELEKTROLUMINESZENZVORRICHTUNG

DISPOSITIF ELECTROLUMINESCENT ORGANIQUE

(84) Designated Contracting States:
**AT BE BG CH CY CZ DE DK EE ES FI FR GB GR HU IE IT LI LU MC NL PT RO SE SI SK TR**

(30) Priority: **24.01.2003 JP 2003016505**

(43) Date of publication of application:
**26.10.2005 Bulletin 2005/43**

(73) Proprietor: **IDEMITSU KOSAN CO., LTD.**
**Tokyo 100-8321 (JP)**

(72) Inventors:
- **ARAKANE, Takashi**
**Sodegaura-shi Chiba 2990293 (JP)**
- **IWAKUMA, Toshihiro**
**Sodegaura-shi Chiba 2990293 (JP)**
- **HOSOKAWA, Chishio**
**Sodegaura-shi Chiba 2990293 (JP)**

(74) Representative: **Gille Hrabal**
**Brucknerstrasse 20**
**40593 Düsseldorf (DE)**

(56) References cited:
**EP-A- 1 551 206** **EP-A- 1 571 193**
**WO-A1-01/72927** **JP-A- 8 319 482**
**JP-A- 2002 056 976** **JP-A- 2002 100 476**
**JP-A- 2002 151 267** **JP-A- 2003 229 275**
**US-A1- 2002 028 329** **US-A1- 2002 045 061**
**US-A1- 2009 191 427**

- **JABBOUR G E ET AL: "HIGH-EFFICIENCY ORGANIC ELECTROPHOPHORESCENT DEVICES THROUGH BALANCE OF CHARGE INJECTION" APPLIED PHYSICS LETTERS, AIP, AMERICAN INSTITUTE OF PHYSICS, MELVILLE, NY, US, vol. 80, no. 11, 18 March 2002 (2002-03-18), pages 2026-2028, XP001108475 ISSN: 0003-6951**
- **KUWABARA Y ET AL: "THERMALLY STABLE MULTILAYERED ORGANIC EL DEVICES USING NOVEL STARBURST MOLECULES, 4,4',4''-TRI (N-CARBAZOYL)TRIPHENYLAMINE (TCTA) AND 4,4',4''-TRIS(3-METHYLPHENYLPHENYLAMINO) TR IPHENYLAMINE (M-MTDATA), AS HOLE-TRANSPORT MATERIALS" ADVANCED MATERIALS, WILEY VCH, WEINHEIM, DE, vol. 6, no. 9, September 1994 (1994-09), pages 677-679, XP001203489 ISSN: 0935-9648**
- **ZHOU X ET AL: "High-efficiency electrophosphorescent organic light-emitting diodes with double light-emitting layers", APPLIED PHYSICS LETTERS, AIP, AMERICAN INSTITUTE OF PHYSICS, MELVILLE, NY, US, vol. 81, no. 21, 18 November 2002 (2002-11-18), pages 4070-4072, XP012032604, ISSN: 0003-6951, DOI: 10.1063/1.1522495**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 589 789 B1

**Description**

TECHNICAL FIELD

The present invention relates to organic electroluminescence devices, and more particularly to organic electroluminescence devices utilizing a phosphorescent light emission which exhibit a favorable efficiency of light emission even when applying a low driving voltage thereto, and have a long lifetime.

BACKGROUND ART

The organic electroluminescence devices ("electroluminescence" will be hereinafter occasionally referred to merely as "EL") are spontaneous light emitting devices which utilize the principle that a fluorescent substance emits light by energy of recombination between holes injected from an anode and electrons injected from a cathode upon application of an electric field thereto. Since C. W. Tang, et al., of Eastman Kodak Company have reported organic EL devices of a laminate type driven at a low electric voltage (C. W. Tang and S. A. Vanslyke, "Applied Physics Letters", Vol. 51, p. 913, 1987, etc.), many studies have been intensely conducted on organic EL devices made of organic materials. The organic EL devices reported by Tang, et al., have such a laminate structure including a light emitting layer made of tris(8-hydroxyquinolinol)aluminum and a hole transport layer made of a triphenyl diamine derivative. The laminate structure of these devices has advantages such as increased efficiency of hole injection into the light emitting layer, increased efficiency of production of excited particles (excitons) which are produced by blocking electrons injected from a cathode and recombining the electrons with holes, and confinement of the excitons produced within the light emitting layer. As the structure of such organic EL devices, there are well known a two-layer structure including a hole transporting (injecting) layer and an electron transporting and light emitting layer, a three-layer structure including a hole transporting (injecting) layer, a light emitting layer and an electron transporting (injecting) layer, etc. In these organic EL devices of a laminate type, various structures and production methods thereof have been proposed in order to enhance an efficiency of recombination between holes and electrons injected thereinto.

In addition, as the light emitting materials for the organic EL devices, there are known chelate complexes such as tris(8-quinolinolato)aluminum complexes, coumarin derivatives, tetraphenyl butadiene derivatives, bis-styryl arylene derivatives and oxadiazole derivatives. It has been reported that these light emitting materials emit blue to red light in a visible range, and it is therefore expected to realize color display devices by using these light emitting materials (for example, refer to Japanese Patent Application Laid-Open Nos. Heisei 8(1996)-239655, Heisei 7(1995)-138561 and Heisei 3(1991)-200289, etc.).

On the other hand, there have also been recently proposed organic EL devices having a light emitting layer made of an organic phosphorescent material in addition to the light emitting material (for example, refer to D.F. O'Brien and M.A. Baldo, et al., "Improved Energy Transfer in Electrophosphorescent Devices", Applied Physics Letters, Vol. 74, No. 3, pp. 442-444, January 18, 1999, and M.A. Baldo, et al., "Very High-Efficiency Green Orange Light-Emitting Devices based on Electrophosphorescence ", Applied Physics Letters, Vol. 75, No. 1, pp. 4-6, July 5, 1999).

Thus, the organic EL devices have achieved a high efficiency of light emission by utilizing singlet and triplet excitation states of the organic phosphorescent material contained in the light emitting layer. It is considered that when electrons and holes are recombined with each other in the organic EL devices, singlet excitons and triplet excitons are produced at a ratio of 1:3 due to the difference in spin multiplicity therebetween. Therefore, if the phosphorescent light emitting material is used in the organic EL devices, it is considered that the efficiency of light emission thereof reaches 3 to 4 times that of the devices using a fluorescent material solely.

In these organic EL devices, in order to prevent the triplet excitation state or triplet excitons from being extinguished, there has been conventionally used such a laminate structure composed sequentially of an anode, a hole transporting layer, an organic light emitting layer, an electron transporting layer (hole blocking layer), an electron injecting layer and a cathode. The hole transporting layer serves for enhancing an efficiency of injection of holes, and has been conventionally produced from an arylamine-based hole transporting material (for example, refer to U.S. Patent No. 6,097,147 and International Patent Application Published under PCT No. WO 01/41512).

However, the arylamine-based compounds conventionally used as the hole transporting material exhibit a triplet energy lower than 2.5 eV owing to a condensed aromatic ring contained therein, whereas the excitation state generated in the light emitting layer is concerned with a triplet state and the excitation energy is larger than 2.5 eV. For this reason, it was recognized that the devices containing the arylamine-based hole transporting material suffer from extinguishing phenomenon of the excitation state. For example, biscarbazole used as a host material for the light emitting layer exhibits a triplet energy of 2.81 eV, and a phosphorescent material used as a dopant therefor in which three phenylpyridyl groups are coordinated to Ir exhibits an excitation energy of 2.55 eV. Such an extinguishing phenomenon becomes more remarkable as the excitation energy is increased, and inhibits generation of a blue light emission with a high efficiency.

The European patent application EP 1 551 206 A1 is a document under Article 54(3) EPC. This document

discloses configurations for electroluminescent devices with the following layered structures:

ITO/CuPc/TPAC/PB102+K-3/Alq/Alq+Li/Al,
ITO/CuPc/TPAC/PB115+K-3/Alq/Alq+Li/Al,
ITO/CuPc/TPAC/PB102+K-3/BAlq+Li/Al,
ITO/TPAC/PB115+K-10/Alq/Alq+Li/Al,
ITO/CuPc/TCTA/PB115+K-23/A-7/Alq+Li/Al, and
ITO/CuPc/TCTA/PB115+K-23/C-15/Alq+Li/Al,

wherein
ITO is indium-tin-oxide,
CuPc is copper phthalocyanine,
TPAC is represented by the following formula:

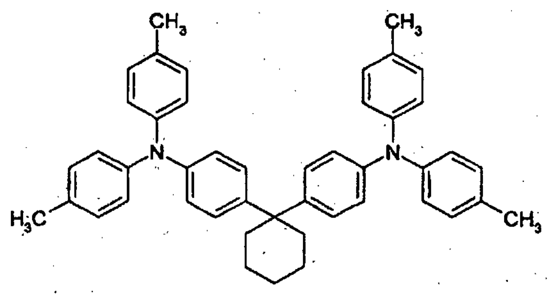

TCTA is represented by the following formula:

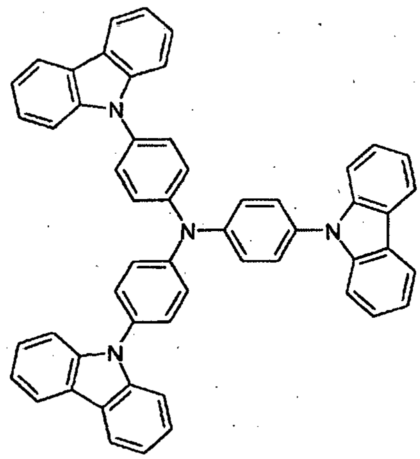

PB102 is represented by the following formula:

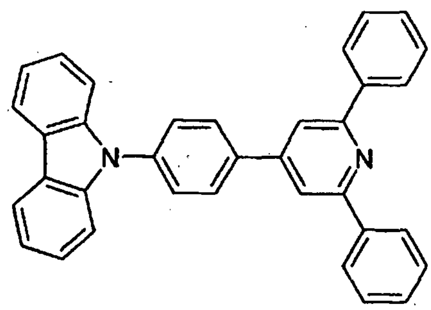

PB115 is represented by the following formula:

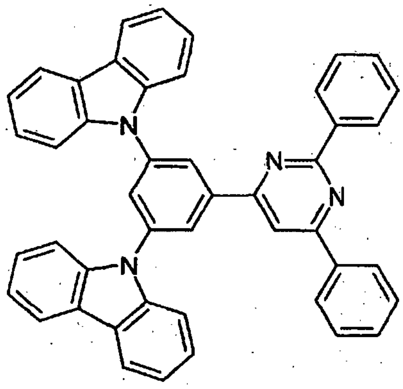

K-3 is represented by the following formula:

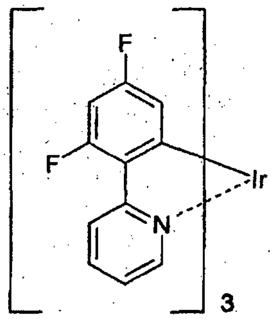

K-10 is represented by the following formula:

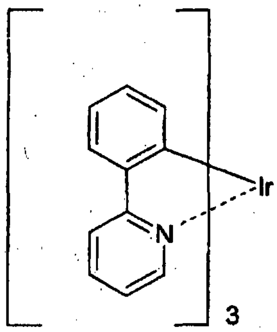

K-23 is represented by the following formula:

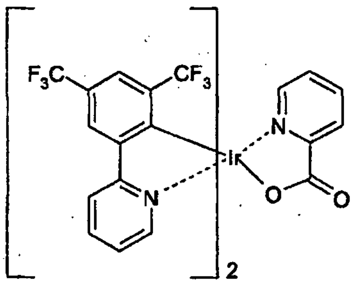

Alq is represented by the following formula:

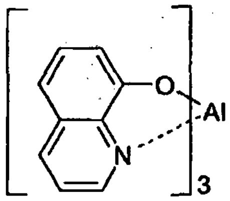

BAlq is represented by the following formula:

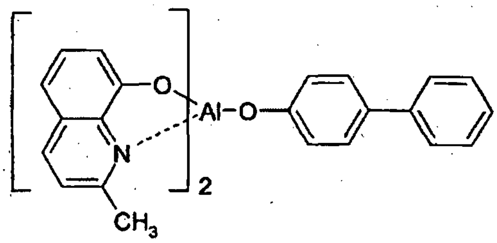

A-7 is represented by the following formula:

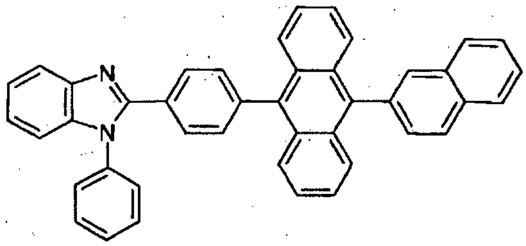

and C-15 is represented by the following formula:

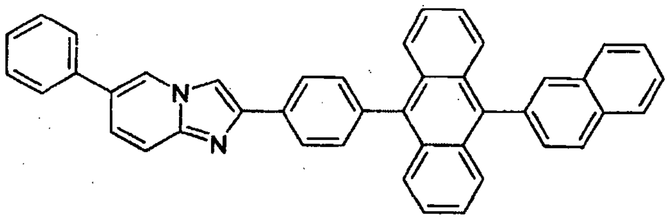

The electrophosphoresecent organic light-emitting diodes with double light-emitting layers which are described by X. Zhou et al (in: Applied Physics Letters, 2002; 81 (21), 4070-4072) contain the compound 4,7-diphenyl-1,10-phenanthroline (BPhen) as an electron-transporting host material.

The document US 2002/0028329 A1 describes organic electroluminescent devices comprising a cathode, an anode and between these layers a hole transporting layer and a light emitting layer. The hole transporting material in the hole transporting layer preferably has a triplet energy of 68 to 90 kcal/mol.

The document US2002/0045061 A1 describes organic electroluminescent devices comprising a cathode, an anode and between these layers a hole injecting layer and a light emitting layer. The compound in the hole injecting layer is preferred to have an electron mobility of 1 $\times$ $10^{-6}$ $cm^2/Vs$ or more. Further organic electroluminescent devices are described in US 2009/019427 A1. These devices have two hole-blocking layers.

DISCLOSURE OF THEINTENTION

The present invention has been made to overcome the above problems. An object of the present invention is to provide organic EL devices utilizing a phosphorescent light emission which exhibit a favorable efficiency of light emission even when applying a low driving voltage thereto, and have a long lifetime.

As a result of extensive researches for accomplishing the above object as well as intensive studies on hole transporting materials, the inventors have found that in order to suppress occurrence of the extinguishing phenomenon,

it is required that the triplet energy of the hole transporting materials is 2.52 eV or higher and preferably 2.8 eV or higher. However, for example, polyvinyl carbazole used as the hole transporting material has a triplet energy of 2.52 eV or higher which is enough to prevent the extinguishing phenomenon, but exhibits a low hole mobility and, therefore, a high resistance, resulting in necessity of a unpractically high driving voltage. In consequence, it has been found that in order to obtain organic EL devices having a favorable efficiency of light emission even when applying a low driving voltage thereto, and a long lifetime, it is required to use a hole transporting material having not only a triplet energy of 2.52 eV or higher but also a hole mobility of $10^{-6}$ $cm^2/Vs$ or higher as measured at a field intensity of 0.1 to 0.6 MV/cm. The present invention has been accomplished on the basis of the above finding.

Thus, the present invention provides an organic EL device comprising a cathode, an anode and sandwiched between the cathode and the anode, at least a hole transporting layer and a light emitting layer containing a phosphorescent light emitting material and a host material, wherein the hole transporting layer comprises a hole transporting material having a triplet energy of 2.52 to 3.70 eV and a hole mobility of $10^{-6}$ $cm^2/Vs$ or higher as measured at a field intensity of 0.1 to 0.6 MV/cm.

EMBODIMENTS FOR CARRYING OUT THE INVENTION

The organic EL device of the present invention comprises a cathode, an anode and, sandwiched between the cathode and the anode, at least a hole transporting layer and a light emitting layer containing a phosphorescent light emitting material and a host material, wherein the hole transporting layer comprises a hole transporting material having a triplet energy of 2.52 to 3.70 eV and a hole mobility of $10^{-6}$ $cm^2/Vs$ or higher as measured at a field intensity of 0.1 to 0.6 MV/cm.

The triplet energy of the hole transporting material used in the present invention is preferably in the range of 2.76 to 3.70 eV and more preferably 2.85 to 3.4 eV. When the triplet energy of the hole transporting material is less than 2.52 eV, the organic EL device fails to emit light. When the triplet energy of the hole transporting material exceeds 3.70 eV, the hole transporting material tends to lose an aromatic property, so that it may be difficult to transport holes therethrough.

The ionization potential of the hole transporting material used in the present invention is preferably 5.8 eV or lower because of facilitated injection of holes from the electrode or the hole injecting layer thereinto as well as stabilization of the resultant device, and more preferably 5.6 eV or lower.

Examples of the hole transporting material used in the present invention which has a triplet energy of 2.52 to 3.70 eV and a hole mobility of $10^{-6}$ $cm^2/Vs$ or higher as measured at a field intensity of 0.1 to 0.6 MV/cm, include those compounds represented by the following general formulae (1) to (4):

Diamine compounds represented by the general formula (1):

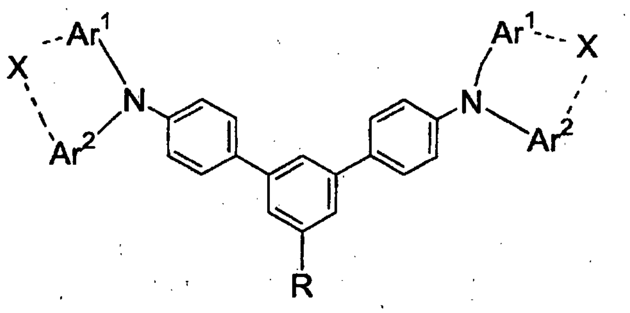

(1)

wherein $Ar^1$ and $Ar^2$ each independently represents a substituted or unsubstituted aryl group having 6 to 18 nuclear carbon atoms; R represents a substituted or unsubstituted alkyl group having 4 to 6 carbon atoms, a substituted or unsubstituted alkoxy group, or a substituted or unsubstituted aryl group having 6 to 30 nuclear carbon atoms; and X represents a single bond, an alkylene group, a phenylene group or a coupling group expressed as -O- or -S-, further, X may be present or absent;

Triamine compounds represented by the general formula (2):

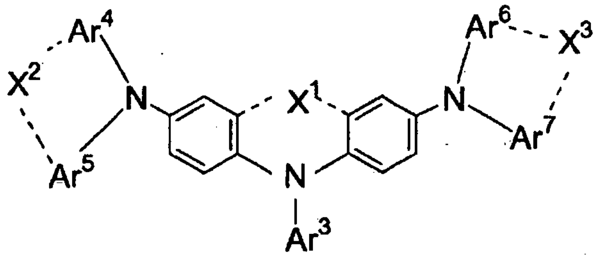

(2)

wherein $Ar^3$ represents a substituted or unsubstituted aryl group having 6 to 18 nuclear carbon atoms; $Ar^4$ to $Ar^7$ each independently represents a substituted or unsubstituted arylene group having 6 to 18 nuclear carbon atoms; $X^1$ represents a single bond, a coupling group expressed as -O- , -S-, a substituted or unsubstituted alkylene group having 1 to 4 carbon atoms or a substituted or unsubstituted arylene group having 1 to 30 carbon atoms, each of which may be present or absent; and $X^2$ and $X^3$ each independently represents a single bond, -O- , -S-, a substituted or unsubstituted alkylene group having 1 to 4 carbon atoms or a substituted or unsubstituted arylene group having 1 to 30 carbon atoms, and $X^2$ and $X^3$ may be the same with or different from each other;

Compounds represented by the general formula (3):

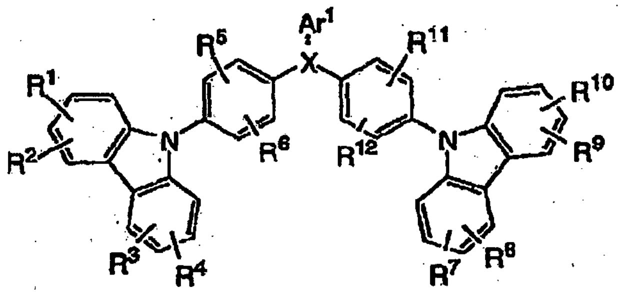

(3)

wherein $R^1$ to $R^{12}$ each independently represents a hydrogen atom, a halogen atom, a substituted or unsubstituted alkyl group having 1 to 8 carbon atoms, a substituted or unsubstituted aralkyl group having 6 to 20 carbon atoms, a substituted or unsubstituted alkenyl group having 3 to 30 carbon atoms, a cyano group, a substituted or unsubstituted amino group, an acyl group, a substituted or unsubstituted alkoxycarbonyl group having 2 to 30 carbon atoms, a carboxyl group, a substituted or unsubstituted alkoxy group having 1 to 30 carbon atoms, a substituted or unsubstituted alkylamino group having 2 to 30 carbon atoms, a substituted or unsubstituted aralkylamino group having 6 to 30 carbon atoms, a hydroxyl group, a substituted or unsubstituted aryloxy group having 6 to 30 carbon atoms, a substituted or unsubstituted aryl group having 5 to 50 carbon atoms or a substituted or unsubstituted aromatic heterocyclic group having 3 to 40 carbon atoms, and $R^1$ and $R^2$, $R^3$ and $R^4$, $R^5$ and $R^6$, $R^7$ and $R^8$, $R^9$ and $R^{10}$, or $R^{11}$ and $R^{12}$ may form a ring through adjacent substituent groups respectively bonded thereto;

X represents a trivalent coupling group expressed by any of the following formulae:

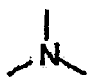

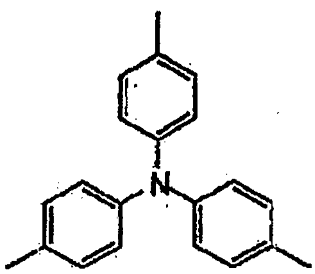

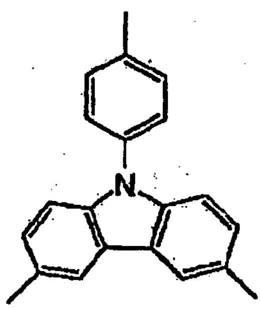

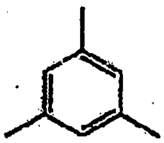
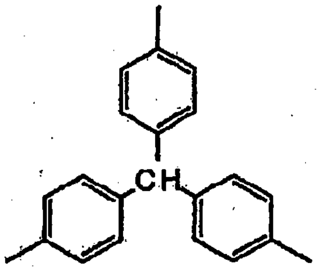
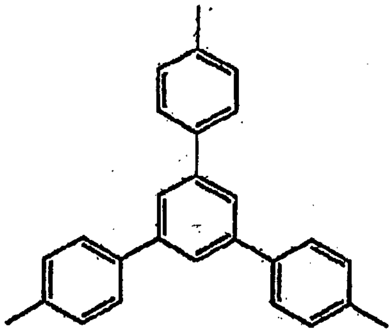

$Ar^8$ represents a substituted or unsubstituted aryl group having 5 to 50 carbon atoms, a substituted or unsubstituted aromatic heterocyclic group having 3 to 40 carbon atoms, or a group expressed by the following general formula (3'):

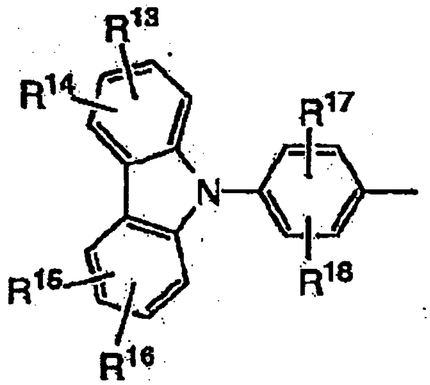

(3')

wherein $R^{13}$ to $R^{18}$ each independently represents a hydrogen atom, a halogen atom, a substituted or unsubstituted alkyl group having 1 to 20 carbon atoms, a substituted or unsubstituted aralkyl group having 6 to 30 carbon atoms, a substituted or unsubstituted alkenyl group having 3 to 30 carbon atoms, a cyano group, a substituted or unsubstituted amino group, an acyl group, a substituted or unsubstituted alkoxycarbonyl group having 2 to 30 carbon atoms, a carboxyl group, a substituted or unsubstituted alkoxy group having 1 to 30 carbon atoms, a substituted or unsubstituted alkylamino group having 6 to 30 carbon atoms, a substituted or unsubstituted aralkylamino group having 6 to 30 carbon atoms, a hydroxyl group, a substituted or unsubstituted aryloxy group having 6 to 30 carbon atoms, a substituted or unsubstituted aryl group having 5 to 50 carbon atoms or a substituted or unsubstituted aromatic heterocyclic group having 3 to 40 carbon atoms, and $R^{13}$ and $R^{14}$, $R^{15}$ and $R^{16}$, or $R^{17}$ and $R^{18}$ may form a ring through adjacent substituent groups respectively bonded thereto; and

Compounds represented by the following general formula (4):

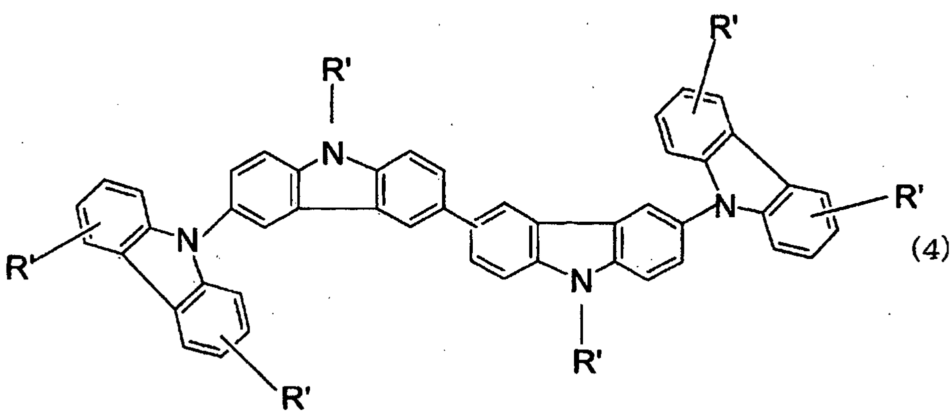

(4)

wherein R' groups each independently represents a hydrogen atom, a substituted or unsubstituted alkyl group having 1 to 30 carbon atoms, a substituted or unsubstituted aralkyl group having 7 to 30 carbon atoms, a substituted or unsubstituted-

stituted amino group, an acyl group, a substituted or unsubstituted alkoxycarbonyl group having 2 to 30 carbon atoms, a carboxyl group, a substituted or unsubstituted alkoxy group having 1 to 30 carbon atoms, a substituted or unsubstituted alkylamino group having 1 to 30 carbon atoms, a substituted or unsubstituted aralkylamino group having 7 to 30 carbon atoms, a hydroxyl group, a substituted or unsubstituted aryloxy group having 6 to 30 carbon atoms, a substituted or unsubstituted aryl group having 5 to 50 carbon atoms or a substituted or unsubstituted aromatic heterocyclic group having 3 to 40 carbon atoms.

Specific examples of the respective groups represented by $Ar^1$ to $Ar^8$, $X^1$ to $X^3$, $R^1$ to $R^{18}$, and R and R' in the above general formulae (1) to (4) include the below-mentioned groups having the above-specified number of carbon atoms.

Specific examples of the halogen atom include fluorine, chlorine, bromine and iodine.

The substituted or unsubstituted amino group is represented by the formula: $-NX^4X^5$. Examples of the groups represented by $X^4$ and $X^5$ include a hydrogen atom, methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, 1,2.3-trinitropropyl, phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 4-styrylphenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthridinyl, 2-phenanthridinyl, 3-phenanthridinyl, 4-phenanthridinyl, 6-phenanthridinyl, 7-phenanthridinyl, 8-phenanthridinyl, 9-phenanthridinyl, 10-phenanthridinyl, 1-acridinyl, 2-acridinyl, 3-acridinyl, 4-acridinyl, 9-acridinyl, 1,7-phenanthrolin-2-yl, 1,7-phenanthrolin-3-yl, 1,7-phenanthrolin-4-yl, 1,7-phenanthrolin-5-yl, 1,7-phenanthrolin-6-yl, 1,7-phenanthrolin-8-yl, 1,7-phenanthrolin-9-yl, 1,7-phenanthrolin-10-yl, 1,8-phenanthrolin-2-yl, 1,8-phenanthrolin-3-yl, 1,8-phenanthrolin-4-yl, 1,8-phenanthrolin-5-yl, 1,8-phenanthrolin-6-yl, 1,8-phenanthrolin-7-yl, 1,8-phenanthrolin-9-yl, 1,8-phenanthrolin-10-yl, 1,9-phenanthrolin-2-yl, 1,9-phenanthrolin-3-yl, 1,9-phenanthrolin-4-yl, 1,9-phenanthrolin-5-yl, 1,9-phenanthrolin-6-yl, 1,9-phenanthrolin-7-yl, 1,9-phenanthrolin-8-yl, 1,9-phenanthrolin-10-yl, 1,10-phenanthrolin-2-yl, 1,10-phenanthrolin-3-yl, 1,10-phenanthrolin-4-yl, 1,10-phenanthrolin-5-yl, 2,9-phenanthrolin-1-yl, 2,9-phenanthrolin-3-yl, 2,9-phenanthrolin-4-yl, 2,9-phenanthrolin-5-yl, 2,9-phenanthrolin-6-yl, 2,9-phenanthrolin-7-yl, 2,9-phenanthrolin-8-yl, 2,9-phenanthrolin-10-yl, 2,8-phenanthrolin-1-yl, 2,8-phenanthrolin-3-yl, 2,8-phenanthrolin-4-yl, 2,8-phenanthrolin-5-yl, 2,8-phenanthrolin-6-yl, 2,8-phenanthrolin-7-yl, 2,8-phenanthrolin-9-yl, 2,8-phenanthrolin-10-yl, 2,7-phenanthrolin-1-yl, 2,7-phenanthrolin-3-yl, 2,7-phenanthrolin-4-yl, 2,7-phenanthrolin-5-yl, 2,7-phenanthrolin-6-yl, 2,7-phenanthrolin-8-yl, 2,7-phenanthrolin-9-yl, 2,7-phenanthrolin-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrol-1-yl, 2-methylpyrrol-3-yl, 2-methylpyrrol-4-yl, 2-methylpyrrol-5-yl, 3-methylpyrrol-1-yl, 3-methylpyrrol-2-yl, 3-methylpyrrol-4-yl, 3-methylpyrrol-5-yl, 2-t-butylpyrrol-4-yl, 3-(2-phenylpropyl)pyrrol-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl and 4-t-butyl-3-indolyl.

Specific examples of the substituted or unsubstituted alkyl group include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl and 1,2.3-trinitropropyl.

Examples of the substituted or unsubstituted alkenyl group include vinyl, allyl, 1-butenyl, 2-butenyl, 3-butenyl, 1,3-butanedienyl, 1-methylvinyl, styryl, 2,2-diphenylvinyl, 1,2-diphenylvinyl, 1-methylallyl, 1,1-dimethylallyl, 2-methylallyl, 1-phenylallyl, 2-phenylallyl, 3-phenylallyl, 3,3-diphenylallyl, 1,2-dimethylallyl, 1-phenyl-1-butenyl and 3-phenyl-1-butenyl.

The substituted or unsubstituted alkoxy group is represented by the formula: -OY. Examples of the group Y include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl and 1,2.3-trinitropropyl.

Examples of the substituted or unsubstituted aryl group include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl and 4"-t-butyl-p-terphenyl-4-yl. Examples of the preferred aryl group having 6 to 18 carbon atoms include phenyl, naphthyl, anthryl, phenanthryl, naphthacenyl and pyrenyl.

Examples of the substituted or unsubstituted aromatic heterocyclic group include 1-pyrrolyl, 2-pyrrolyl, 3-pyrrolyl, pyrazinyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthridinyl, 2-phenanthridinyl, 3-phenanthridinyl, 4-phenanthridinyl, 6-phenanthridinyl, 7-phenanthridinyl, 8-phenanthridinyl, 9-phenanthridinyl, 10-phenanthridinyl, 1-acridinyl, 2-acridinyl, 3-acridinyl, 4-acridinyl, 9-acridinyl, 1,7-phenanthrolin-2-yl, 1,7-phenanthrolin-3-yl, 1,7-phenanthrolin-4-yl, 1,7-phenanthrolin-5-yl, 1,7-phenanthrolin-6-yl, 1,7-phenanthrolin-8-yl, 1,7-phenanthrolin-9-yl, 1,7-phenanthrolin-10-yl, 1,8-phenanthrolin-2-yl, 1,8-phenanthrolin-3-yl, 1,8-phenanthrolin-4-yl, 1,8-phenanthrolin-5-yl, 1,8-phenanthrolin-6-yl, 1,8-phenanthrol.in-7-yl, 1,8-phenanthrolin-9-yl, 1,8-phenanthrolin-10-yl, 1,9-phenanthrolin-2-yl, 1,9-phenanthrolin-3-yl, 1,9-phenanthrolin-4-yl, 1,9-phenanthrolin-5-yl, 1,9-phenanthrolin-6-yl, 1,9-phenanthrolin-7-yl, 1,9-phenanthrolin-8-yl, 1,9-phenanthrolin-10-yl, 1,10-phenanthrolin-2-yl, 1,10-phenanthrolin-3-yl, 1,10-phenanthrolin-4-yl, 1,10-phenanthrolin-5-yl, 2,9-phenanthrolin-1-yl, 2,9-phenanthrolin-3-yl, 2,9-phenanthrolin-4-yl, 2,9-phenanthrolin-5-yl, 2,9-phenanthrolin-6-yl, 2,9-phenanthrolin-7-yl, 2,9-phenanthrolin-8-yl, 2,9-phenanthrolin-10-yl, 2,8-phenanthrolin-1-yl, 2,8-phenanthrolin-3-yl, 2,8-phenanthrolin-4-yl, 2,8-phenanthrolin-5-yl, 2,8-phenanthrolin-6-yl, 2,8-phenanthrolin-7-yl, 2,8-phenanthrolin-9-yl, 2,8-phenanthrolin-10-yl, 2,7-phenanthrolin-1-yl, 2,7-phenanthrolin-3-yl, 2,7-phenanthrolin-4-yl, 2,7-phenanthrolin-5-yl, 2,7-phenanthrolin-6-yl, 2,7-phenanthrolin-8-yl, 2,7-phenanthrolin-9-yl, 2,7-phenanthrolin-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrol-1-yl, 2-methylpyrrol-3-yl, 2-methylpyrrol-4-yl, 2-methylpyrrol-5-yl, 3-methylpyrrol-1-yl, 3-methylpyrrol-2-yl, 3-methylpyrrol-4-yl, 3-methylpyrrol-5-yl, 2-t-butylpyrrol-4-yl, 3-(2-phenylpropyl)pyrrol-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl and 4-t-butyl-3-indolyl.

Examples of the substituted or unsubstituted aralkyl group include benzyl, 1-phenylethyl, 2-phenylethyl, 1-phenylisopropyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl and 1-chloro-2-phenylisopropyl.

The substituted or unsubstituted aryloxy group is represented by the formula: -OZ. Examples of the group Z include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthridinyl, 2-phenanthridinyl, 3-phenanthridinyl, 4-phenanthridinyl, 6-phenanthridinyl, 7-phenanthridinyl, 8-phenanthridinyl, 9-phenanthridinyl, 10-phenanthridinyl, 1-acridinyl, 2-acridinyl, 3-acridinyl, 4-acridinyl, 9-acridinyl, 1,7-phenanthrolin-2-yl, 1,7-phenanthrolin-3-yl, 1,7-phenanthrolin-4-yl, 1,7-phenanthrolin-5-yl, 1,7-phenanthrolin-6-yl, 1,7-phenanthrolin-8-yl, 1,7-phenanthrolin-9-yl, 1,7-phenanthrolin-10-yl, 1,8-phenanthrolin-2-yl, 1,8-phenanthrolin-3-yl, 1,8-phenanthrolin-4-yl, 1,8-phenanthrolin-5-yl, 1,8-phenanthrolin-6-yl, 1,8-phenanthrolin-7-yl, 1,8-phenanthrolin-9-yl, 1,8-phenanthrolin-10-yl, 1,9-phenanthrolin-2-yl, 1,9-phenanthrolin-3-yl, 1,9-phenanthrolin-4-yl, 1,9-phenanthrolin-5-yl, 1,9-phenanthrolin-6-yl, 1,9-phenanthrolin-7-yl, 1,9-phenanthrolin-8-yl, 1,9-phenanthrolin-10-yl, 1,10-phenanthrolin-2-yl, 1,10-phenanthrolin-3-yl, 1,10-phenanthrolin-4-yl, 1,10-phenanthrolin-5-yl, 2,9-phenanthrolin-1-yl, 2,9-phenanthrolin-3-yl, 2,9-phenanthrolin-4-yl, 2,9-phenanthrolin-5-yl, 2,9-phenanthrolin-6-yl, 2,9-phenanthrolin-7-yl, 2,9-phenanthrolin-8-yl, 2,9-phenanthrolin-10-yl, 2,8-phenanthrolin-1-yl, 2,8-phenanthrolin-3-yl, 2,8-phenanthrolin-4-yl, 2,8-phenanthrolin-5-yl, 2,8-phenanthrolin-6-yl, 2,8-phenanthrolin-7-yl, 2,8-phenanthrolin-9-yl, 2,8-phenanthrolin-10-yl, 2,7-phenanthrolin-1-yl, 2,7-phenanthrolin-3-yl, 2,7-phenanthrolin-4-yl, 2,7-phenanthrolin-5-yl, 2,7-phenanthrolin-6-yl, 2,7-phenanthrolin-8-yl, 2,7-phenanthrolin-9-yl, 2,7-phenanthrolin-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrol-1-yl, 2-methylpyrrol-3-yl, 2-methylpyrrol-4-yl, 2-methylpyrrol-5-yl, 3-methylpyrrol-1-yl, 3-methylpyrrol-2-yl, 3-methylpyrrol-4-yl, 3-methylpyrrol-5-yl, 2-t-butylpyrrol-4-yl, 3-(2-phenylpropyl)pyrrol-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl and 4-t-butyl-3-indolyl.

The substituted or unsubstituted alkoxycarbonyl group is represented by the formula: -COOY. Examples of the group Y include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl and 1,2.3-trinitropropyl.

Examples of the substituted or unsubstituted alkylamino group include amino groups which are substituted with the above exemplified alkyl groups.

Examples of the substituted or unsubstituted aralkylamino group include amino groups which are substituted with the above exemplified aralkyl groups.

Examples of the substituted or unsubstituted alkylene group include divalent groups derived from the above exemplified alkyl groups.

Examples of the substituted or unsubstituted arylene group include divalent groups derived from the above exemplified aryl groups.

Examples of the divalent groups capable of forming a ring include tetramethylene, pentamethylene, hexamethylene, diphenylmethane-2,2'-di-yl, diphenylethane-3,3'-di-yl and diphenylpropane-4,4'-di-yl.

Examples of the substituent groups which may be bonded to the above respective groups include a hydrogen atom, a halogen atom, a hydroxyl group, an amino group, a nitro group, a cyano group, an alkyl group, an alkenyl group, a cycloalkyl group, an alkoxy group, an aryl group, an aromatic heterocyclic group, an aralkyl group, an aryloxy group, an alkoxycarbonyl group and a carboxyl group. Specific examples of these substituent groups include the same groups as exemplified above.

In the organic EL device of the present invention, the host material contained in the light emitting layer thereof preferably has a triplet energy of 2.52 eV or higher since the resultant device is capable of emitting a red light. In addition, the triplet energy of the host material contained in the light emitting layer is more preferably 2.76 eV or higher and still more preferably 2.85 eV or higher since the device also has a high capability of emitting a blue light. Further, the triplet

energy of the host material contained in the light emitting layer is preferably 3.70 eV or lower because of facilitated injection of holes or electrons into the host material contained in the light emitting layer.

The host material contained in the light emitting layer exhibits an electron transporting property. The electron transporting property of the host material used herein means any of the following properties (1) and (2):

(1) The host material contained in the light emitting layer is a compound having an electron mobility of $10^{-6}$ $cm^2/Vs$ or higher. The electron mobility may be determined by a time-of-flight (TOF) method or measurement of transient of a space-charge limitation current. The TOF method is described in "Synthetic Metals", 111/112, (2000), p. 331, whereas the measurement of transient of a space-charge limitation current is described in "Electrical Transport in Solids", Pergamon Press, 1981, pp. 346-348.

(2) The recombination of holes and electrons in an anode-side zone of the light emitting layer is more readily caused than that in a cathode-side zone thereof. This corresponds to such a case where when dividing the light emitting layer into two zones such that the device has a layer structure composed of a cathode, an electron injecting layer, a cathode-side light-emitting layer, an anode-side light emitting layer, a hole transporting layer and an anode, and comparing a device AN in which a phosphorescent light emitting compound is added to only the anode-side light emitting layer with a device CA in which a phosphorescent light emitting compound is added to only the cathode-side light emitting layer, the device AN has a higher efficiency of light emission than that of the device CA. In this case, attention should be paid so as not to extinguish the excitation state of the light emitting layers due to the electron injecting layer or the hole transporting layer.

Meanwhile, the electron transporting property does not mean absence of a hole transporting property. Therefore, even if a material having an electron transporting property exhibits a hole mobility of $10^{-7}$ $cm^2/Vs$ or higher upon the measurement, the material may be occasionally regarded as an electron transporting material.

Polycarbazole compounds such as polyvinyl carbazole and biscarbazole conventionally used as the host material of the light emitting layer generally have a hole transporting property and exhibit a low electron transporting capability. When such hole transporting materials are used as the host material of the light emitting layer, the recombination zone is mainly formed near a cathode-side interface of the light emitting layer. In this case, when the electron injecting layer is interposed between the light emitting layer and the cathode, and an electron transporting material having a smaller energy gap than that of the host material in the light emitting layer is incorporated into the electron injecting layer, the excitation state caused around the cathode-side interface of the light emitting layer tends to be deactivated owing to the electron injecting layer, so that the efficiency of light emission is considerably lowered. In addition, when the triplet energy of the electron transporting material contained in the electron injecting layer is smaller than that of the host material contained in the light emitting layer, the excitation state caused around the cathode-side interface of the light emitting layer also tends to be deactivated owing to the electron injecting layer, so that the efficiency of light emission is considerably lowered.

On the other hand, in the case where the host material constituting the light emitting layer, or the light emitting layer itself, exhibits an electron transporting property, the zone of recombination of electrons and holes is separated apart from the interface between the electron injecting layer and the light emitting layer, so that deactivation of the excitation state is effectively prevented.

Further, in the present invention, the host material constituting the light emitting layer is preferably made of an electron-deficient derivative of five-membered ring having nitrogen or an electron-deficient derivative of six-membered ring. The "electron deficiency" used herein means that one or more of carbon atoms of a 6$\pi$ aromatic ring are replaced with nitrogen atoms.

The derivative of five-membered ring having nitrogen has at least one skeleton selected from the group consisting of imidazole, benzimidazole, triazole, tetrazole, oxadiazole, thiadiazole, oxatriazole and thiatriazole, and more preferably has a skeleton of imidazole or benzimidazole.

The derivative of six-membered ring having nitrogen has at least one skeleton selected from the group consisting of triazine, quinoxaline, quinoline, benzopyrimidine, pyridine, pyrazine and pyrimidine, and more preferably has a skeleton of triazine or pyrimidine.

In particular, the host material contained in the light emitting layer is a compound represented by the following general formula (5) or (6).

$$(Cz\text{-})_m A \qquad (5)$$

wherein Cz represents a substituted or unsubstituted carbazolyl group or a substituted or unsubstituted azacarbazolyl group; A represents an aryl-substituted ring group having nitrogen, a diaryl-substituted ring group having nitrogen or a triaryl-substituted ring group having nitrogen; and m is an integer of 1 to 3.

More specifically, depending upon the value of m, the general formula (5) are further expressed by any of the

following formulae:

m = 1: Cz-A

m = 2: Cz-A-Cz

m = 3:

Cz−A(Cz)−Cz.

|

Cz

Cz-$A_n$ (6)

wherein Cz represents a substituted or unsubstituted carbazolyl group or a substituted or unsubstituted azacarbazolyl group; A represents an aryl-substituted nitrogen-containing ring group, a diaryl-substituted nitrogen-containing ring group or a triaryl-substituted nitrogen-containing ring group; and n is an integer of 1 to 3.

More specifically, depending upon the value of n, the general formula (6) is further expressed by any of the following formulae:

n = 1: Cz-A

n = 2: A-Cz-A

n=3:

A−Cz(A)−A.

|

Cz

In the general formulae (5) and (6), the ring having nitrogen is selected from benzimidazole, triazole, tetrazole, oxadiazole, thiadiazole, oxatriazole, thiatriazole, benzopyrinidine, pyridine, quinoline, pyrazine, pyrimidine, quinoxaline, triazine, imidazole and imidazopyridine.

Also, in the general formulae (5) and (6), the ionization potential thereof is determined by the position of Cz, and is in the range of 5.6 to 5.8 eV.

Specific examples of the compounds represented by the general formulae (5) and (6) are as follows, though not particularly limited thereto:

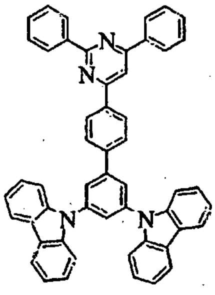
(H-1)

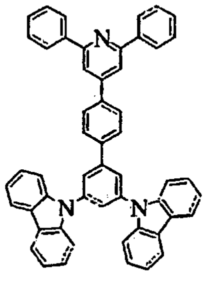
(H-2)

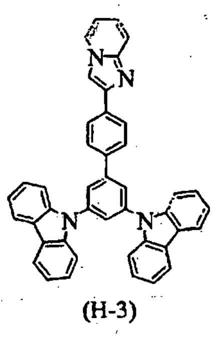
(H-3)

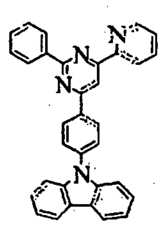
(H-4)

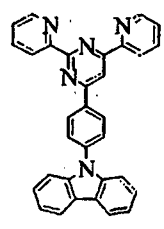
(H-5)

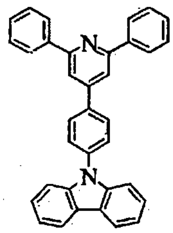
(H-6)

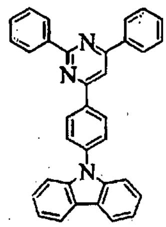
(H-7)

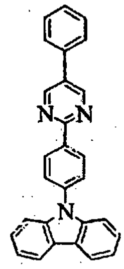
(H-8)

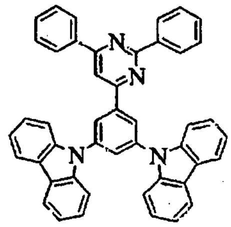
(H-9)

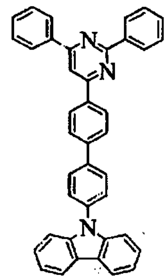
(H-10)

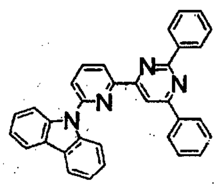
(H-11)

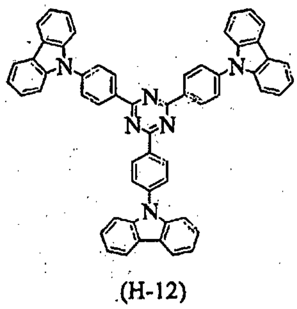
(H-12)

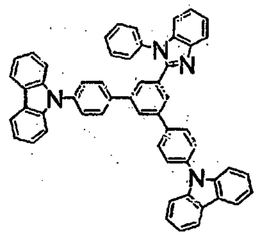
(H-13)

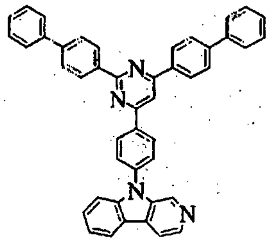
(H-14)

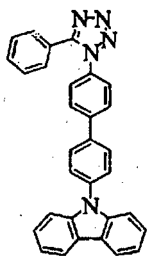
(H-15)

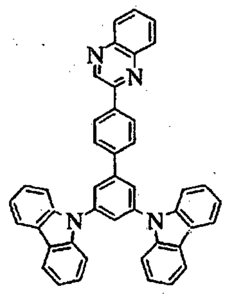
(H-16)

The specific disclosure in EP 1 551 206 A1 which has been described above in the section Background art is excluded from the scope of the claims.

In the organic EL device of the present invention, the phosphorescent light emitting materials to be contained in the light emitting layer are preferably organic metal complexes in view of enhancing an external quantum efficiency of the device. Of these complexes, more preferred are palladium complexes, iridium complexes, osmium complexes and platinum complexes; still more preferred are iridium complexes and platinum complexes; and most preferred are ortho-metallized iridium complexes.

Specific examples of the preferred organic metal complexes are as follows, though not particularly limited thereto:

(K-1)

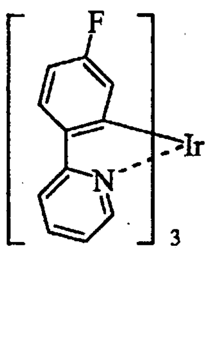

(K-2)

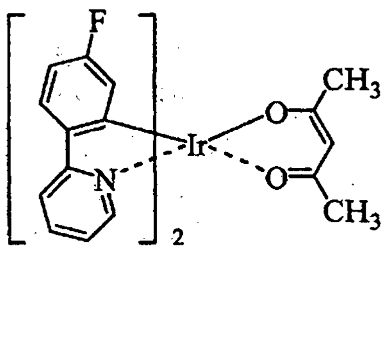

(K-3)

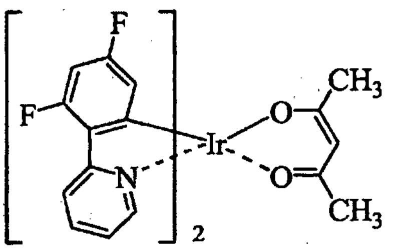

(K-4)

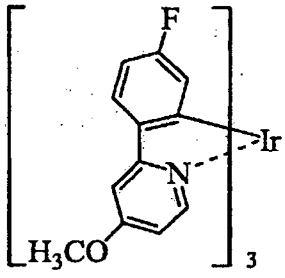

(K-5)

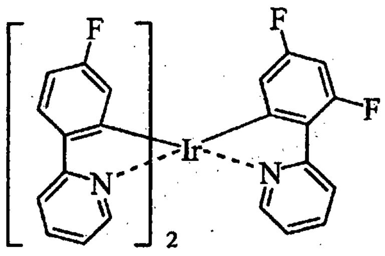

(K-6)

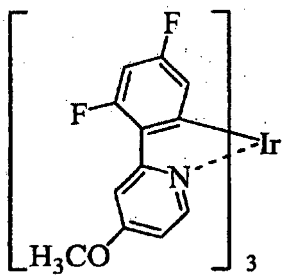

(K-7)

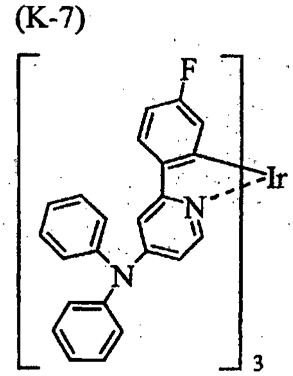

(K-8)

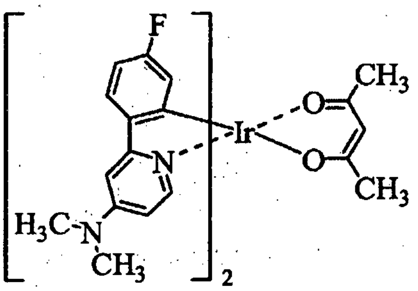

(K-9)

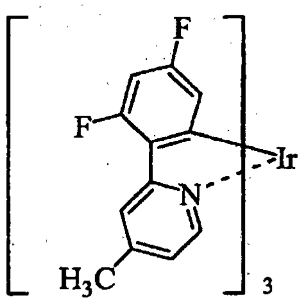

(K-10)

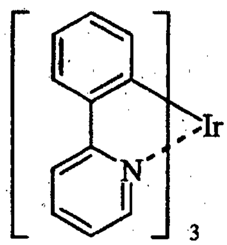

Further, the organic EL device of the present invention is preferably provided with an electron injecting layer. An electron transporting material contained in the electron injecting layer is preferably made of nitrogen-containing complexes in the form of a metal complex containing a single kind of nitrogen-containing ring derivative as a ligand. Examples of the preferred nitrogen-containing ring include quinoline, phenyl pyridine, benzoquinone and phenathroline. Examples of the preferred metal complexes include quinolinol metal complexes and derivatives thereof. Specific examples of the quinolinol metal complexes and derivatives thereof include metal complexes containing a 8-quinolinol derivative as a ligand, for example, tris(8-quinolinol)Al complexes, tris(5,7-dichloro-8-quinolinol)Al complexes, tris(5,7-dibromo-8-quinolinol)Al complexes, tris(2-methyl-8-quinolinol)Al complexes, tris(5-methyl-8-quinolinol)Al complexes, tris(8-quinolinol)Zn complexes, tris(8-quinolinol)In complexes, tris(8-quinolinol)Mg complexes, tris(8-quinolinol)Cu complexes, tris(8-quinolinol)Ca complexes, tris(8-quinolinol)Sn complexes, tris(8-quinolinol)Ga complexes and tris(8-quinolinol)Pb complexes. These metal complexes may be used singly or in combination of any two or more thereof.

These metal complexes are excellent in injection of electrons from the cathode because of a small energy gap thereof, as well as exhibit a high durability to electron transportation, thereby providing devices having a long lifetime.

Specific examples of these metal complexes include the following compounds:

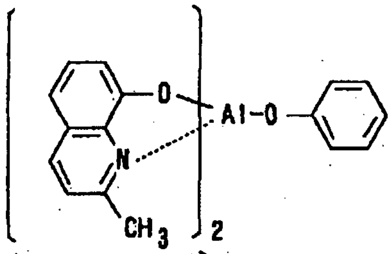

(A-1)

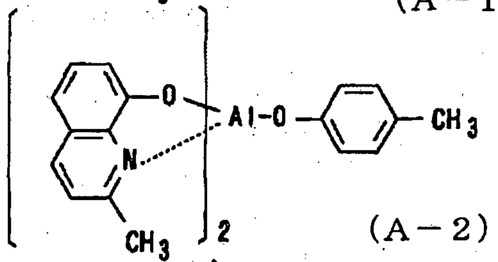

(A-2)

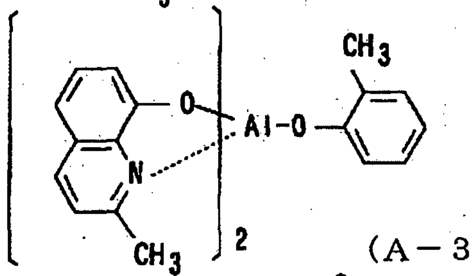

(A-3)

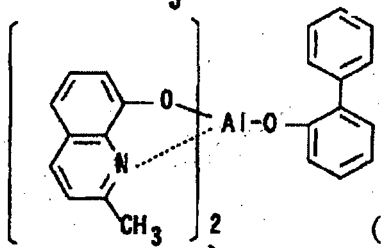

(A-4)

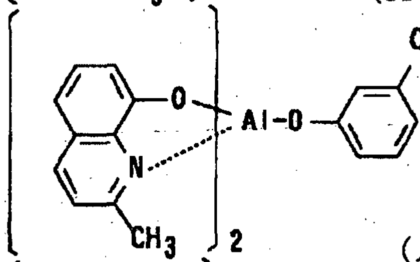

(A-5)

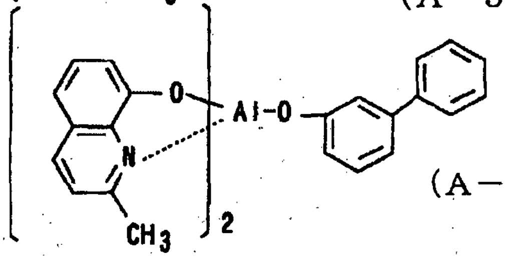

(A-6)

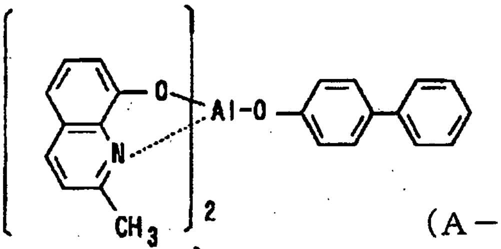

(A－7)

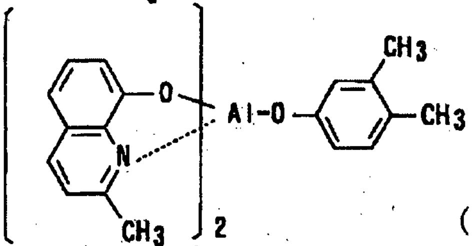

(A－8)

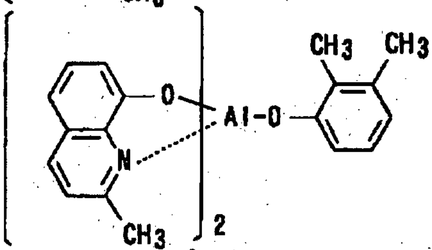

(A－9)

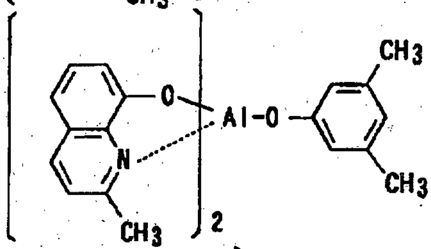

(A－10)

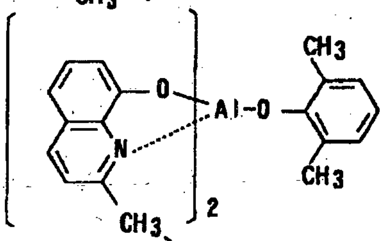

(A－11)

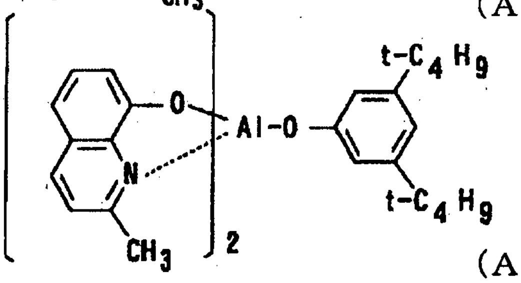

(A－12)

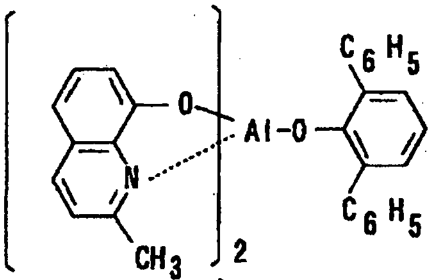

(A－１３)

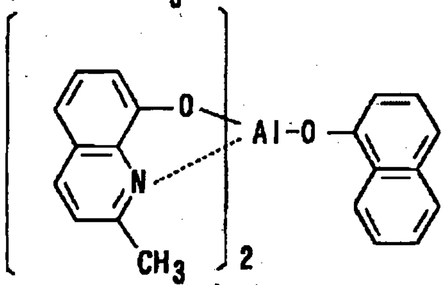

(A－１４)

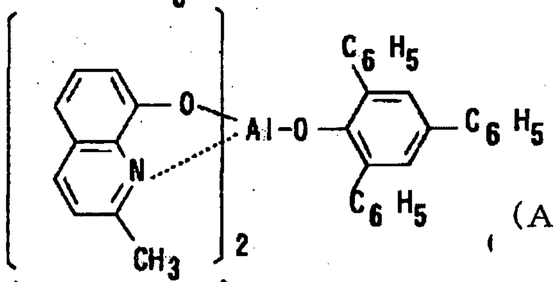

(A－１５)

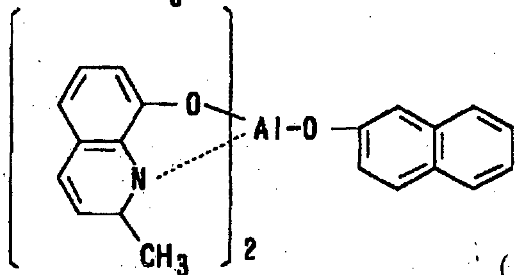

(A－１６)

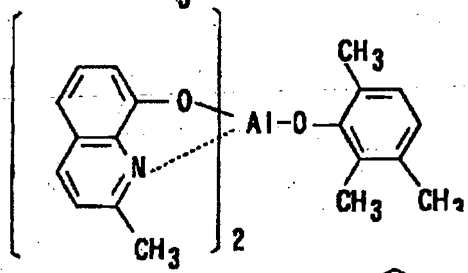

(A－１７)

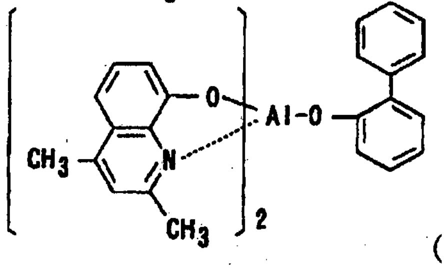

(A－１８)

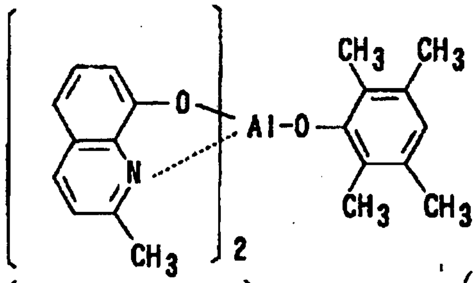

(A−19)

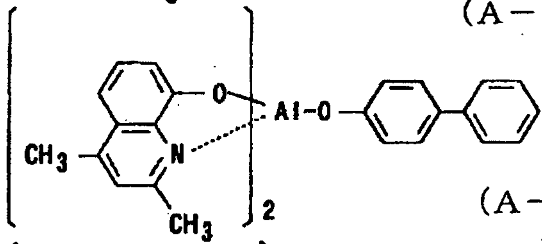

(A−20)

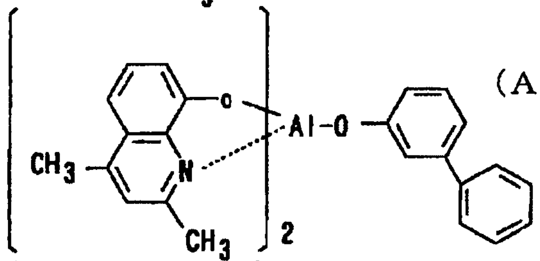

(A−21)

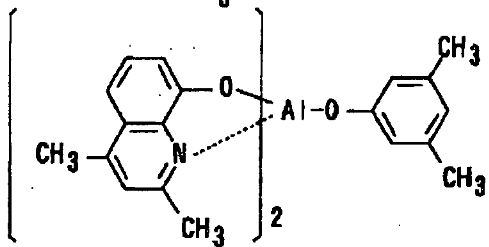

(A−22)

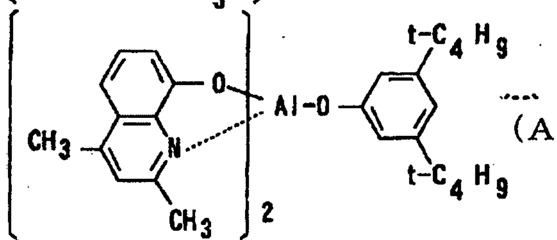

(A−23)

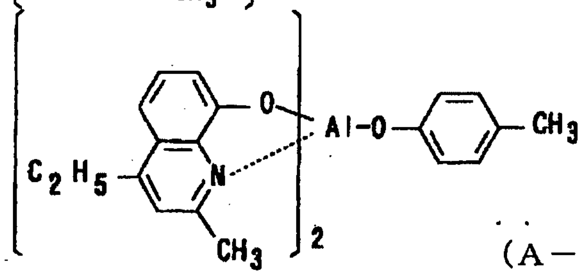

(A−24)

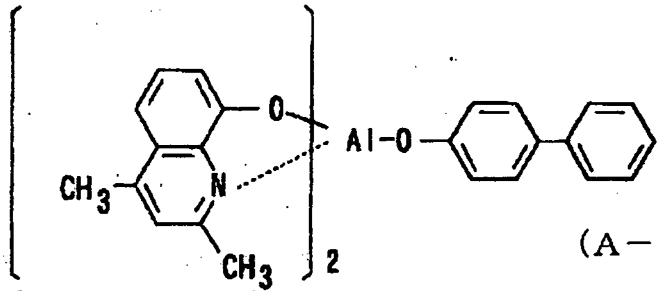

(A－２５)

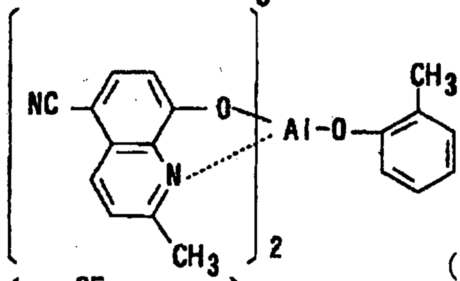

(A－２６)

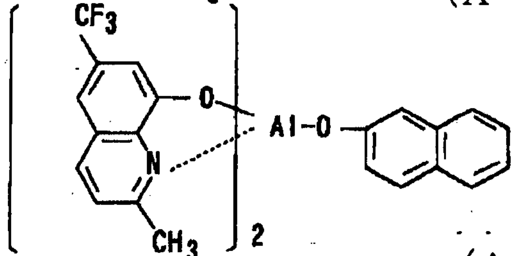

(A－２７)

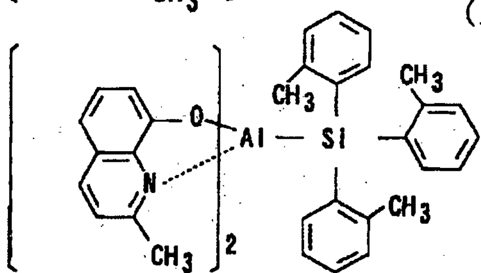

(A－２８)

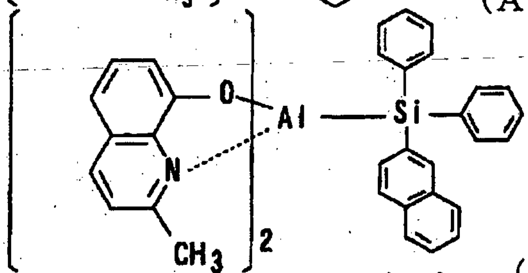

(A－２９)

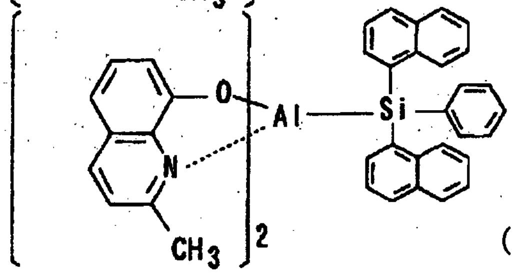

(A－３０)

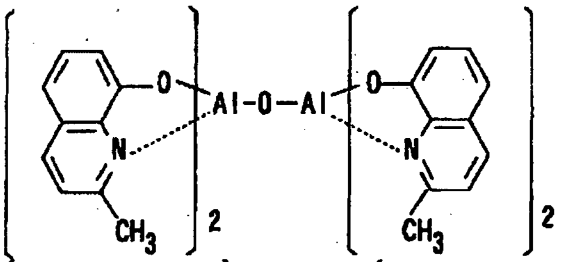

(A-31)

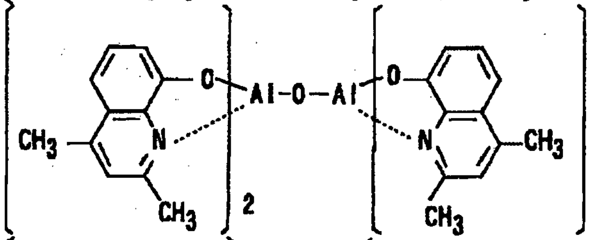

(A-32)

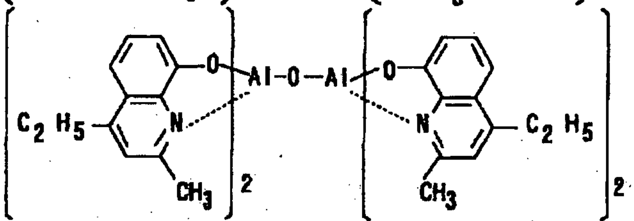

(A-33)

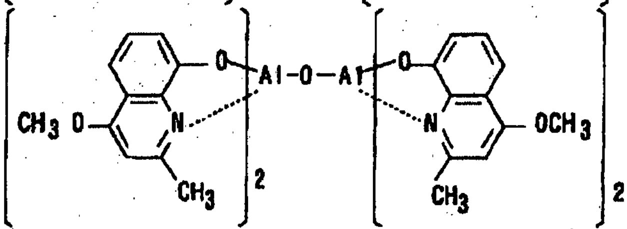

(A-34)

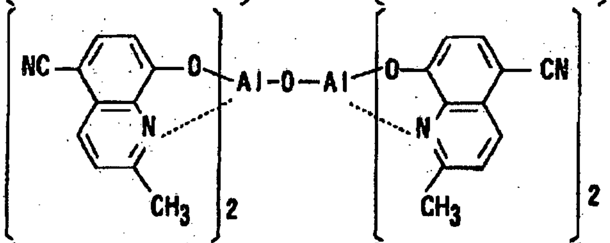

(A-35)

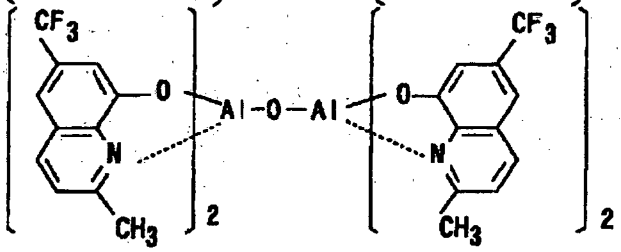

(A-36)

The organic EL device of the present invention is preferably provided, at an interface between the light emitting layer and the hole transporting layer, with a zone where electrons and holes are recombined with each other, or a light emitting zone. The recombination or light emission in such zones means that when a phosphorescent light emitting material is added to the interfacial zone, the efficiency of light emission is enhanced as compared to the case where the phosphorescent light emitting material is added to zones other than the interfacial zone.

Next, the general construction of the organic EL device of the present invention will be explained.

Examples of the construction of the organic EL device according to the present invention include layer structures such as an anode/a hole transporting layer/a light emitting layer/a cathode; an anode/a hole transporting layer/a light emitting layer/an electron injecting layer/a cathode; an anode/a hole injecting layer/a hole transporting layer/a light emitting layer/an electron injecting layer/a cathode; and an anode/an insulting layer/a hole injecting layer/a hole transporting layer/a light emitting layer/an electron injecting layer/a cathode.

In the organic EL device of the present invention, an inorganic compound layer or an electron transporting layer which is made of an insulating material or a semiconductor may be disposed between the electron injecting layer and the cathode. These layers are capable of effectively preventing leakage of current and enhancing an electron injecting property.

As the insulating material, there is preferably used at least one metal compound selected from the group consisting of alkali metal chalcogenides, alkali earth metal chalcogenides, alkali metal halides and alkali earth metal halides. The electron transporting layer made of these alkali metal chalcogenides, etc., is preferred since the electron injecting property thereof can be further enhanced. Specific examples of the preferred alkali metal chalcogenides include $Li_2O$, LiO, $Na_2S$, $Na_2Se$ and NaO. Specific examples of the preferred alkali earth metal chalcogenides include CaO, BaO, SrO, BeO, BaS and CaSe. Specific examples of the preferred alkali metal halides include LiF, NaF, KF, LiCl, KCl and NaCl. Specific examples of the preferred alkali earth metal halides include fluorides such as $CaF_2$, $BaF_2$, $SrF_2$, $MgF_2$ and $BeF_2$, and halides other than these fluorides.

Specific examples of the semiconductor include oxides, nitrides and oxinitrides containing at least one element selected from the group consisting of Ba, Ca, Sr, Yb, Al, Ga, In, Li, Na, Cd, Mg, Si, Ta, Sb and Zn. These semiconductors may be used singly or in combination of any two or more thereof. The inorganic compound constituting the electron transporting layer is preferably in the form of a microcrystalline or amorphous insulating thin film. The electron transporting layer made of such an insulating thin film can be prevented from suffering from pixel deficiency such as dark spots owing to formation of a more uniform thin film. Examples of the inorganic compound include the above-mentioned alkali metal chalcogenides, alkali earth metal chalcogenides, alkali metal halides and alkali earth metal halides.

Further, in the organic EL device of the present invention, a layer which comes into contact with the cathode preferably contains a reductive dopant. The reductive dopant preferably has a work function of 2.9 eV or lower. The reductive dopant is defined as a compound capable of enhancing an electron injection efficiency, and enables at least a part of the electron injecting layer into which the reductive dopant is added, or the interfacial zone thereof, to be reduced and converted into anions.

The reductive dopant added to the interfacial zone is preferably in the form of a layer or an island. As the reductive dopant, there is preferably used at least one substance selected from the group consisting of alkali metals, alkali metal complexes, alkali metal compounds, alkali earth metals, alkali earth metal complexes, alkali earth metal compounds, rare earth metals, rare earth metal complexes and rare earth metal compounds. The alkali metal compounds, alkali earth metal compounds and rare earth metal compounds may be in the form of an oxide or a halide.

Examples of the alkali metals include Na (work function: 2.36 eV), K (work function: 2.28 eV), Rb (work function: 2.16 eV) and Cs (work function: 1.95 eV). The alkali metals are preferably those having a work function of 2.9 eV or lower. Of these alkali metals, preferred are K, Rb and Cs, more preferred are Rb and Cs, and most preferred is Cs.

Examples of the alkali earth metals include Ca (work function: 2.9 eV), Sr (work function: 2.0 to 2.5 eV) and Ba (work function: 2.52 eV). The alkali earth metals are preferably those having a work function of 2.9 eV or lower.

Examples of the rare earth metals include Sc, Y, Ce, Tb and Yb. The rare earth metals are preferably those having a work function of 2.9 eV or lower.

Among these metals as the reductive dopant, the above preferred metals can exhibit a high reducing capability and are capable of enhancing a luminance of light emitted from the organic EL device, and prolonging a lifetime thereof even when they are added to the electron injecting zone in a relatively small amount.

Examples of the alkali metal compounds include alkali metal oxides such as $Li_2O$, $Cs_2O$ and $K_2O$, and alkali metal halides such as LiF, NaF, CsF and KF. Of these alkali metal compounds, preferred are alkali metal oxides and alkali metal fluorides such as LiF, $Li_2O$ and NaF.

Examples of the alkali earth metal compounds include BaO, SrO, CaO and mixtures thereof such as $Ba_xSr_{1-x}O$ ($0<x<1$) and $Ba_xCa_{1-x}O$ ($0<x<1$). Of these alkali earth metal compounds, preferred are BaO, SrO and CaO.

Examples of the rare earth metal compounds include $YbF_3$, $ScF_3$, $ScO_3$, $Y_2O_3$, $Ce_2O_3$, $GdF_3$ and $TbF_3$. Of these rare earth metal compounds, preferred are $YbF_3$, $ScF_3$ and $TbF_3$.

The alkali metal complexes, alkali earth metal complexes and rare earth metal complexes are not particularly limited as long as these complexes respectively contain at least one metal ion selected from alkali metal ions, alkali earth metal ions and rare earth metal ions. Examples of the preferred ligand contained in these complexes include quinolinol, benzoquinolinol, acridinol, phenanthridinol, hydroxyphenyl oxazole, hydroxyphenyl thiazole, hydroxydiaryl oxadiazole, hydroxydiaryl thiadiazole, hydroxyphenyl pyridine, hydroxydiaryl benzoimidazole, hydroxybenzotriazole, hydroxyflavone, bipyridyl, phenanthroline, phthalocyanine, porphyrin, cyclopentadiene, β-diketones, azomethines and derivatives thereof, though not particularly limited thereto.

The layer containing the reductive dopant is preferably produced by the following method. That is, while vapor-depositing the reductive dopant by resistance heating vapor deposition method, an organic substance as the light emitting material or electron injecting material constituting the interfacial zone is vapor-deposited simultaneously, thereby dispersing the reductive dopant in the organic substance. The concentration of dispersion of the layer is controlled such that the molar ratio of the organic substance to the reductive dopant is 100:1 to 1:100 and preferably 5:1 to 1:5. In the

case where the reductive dopant is formed into a layer shape, after forming the light emitting material or electron injecting material constituting the interfacial organic layer into a layer shape, the reductive dopant is singly vapor-deposited thereon by resistance heating vapor deposition method to form a layer having a thickness of preferably 0.1 to 15 nm. In the case where the reductive dopant is formed into an island shape, after forming the light emitting material or electron injecting material constituting the interfacial organic layer into an island shape, the reductive dopant is singly vapor-deposited thereon by resistance heating vapor deposition method to form islands each having a thickness of preferably 0.05 to 1 nm.

The hole transporting layer in the organic EL device of the present invention is the same as described above. Also, the organic EL device of the present invention further include a hole injecting layer. The hole injecting layer is preferably made of a material capable of transporting holes into the light emitting layer under a still lower field intensity. Further, the hole mobility of the hole injecting material is preferably at least $10^{-4}$ $cm^2/V$ -second, for example, upon applying an electric field of $10^4$ to $10^6$ V/cm. The hole injecting material may be optionally selected from conventionally known materials which are ordinarily used as charge transfer materials for holes in photoconductive materials or ordinarily used in the hole injecting layer of organic EL devices.

The hole injecting material is preferably made of a compound which has a hole transporting capability as well as an excellent effect of injecting holes from the anode and further into the light emitting layer or the light emitting material or prevents excitons produced in the light emitting layer from transferring to the electron injecting layer or the electron injecting material, and exhibits an excellent thin film-forming capability. Specific examples of such a compound include phthalocyanine derivatives, naphthalocyanine derivatives, porphyrin derivatives, oxazole, oxadiazole, triazole, imidazole, imidazolone, imidazole thione, pyrazoline, pyrazolone, tetrahydroimidazole, hydrazone, acylhydrazone, polyarylalkane, stilbene, butadiene, benzidine-type triphenylamine, styrylamine-type triphenylamine, diamine-type triphenylamine and derivatives thereof, as well as polymer materials such as polyvinyl carbazole, polysilane and conductive polymers, though not particularly limited thereto.

Of these hole injecting materials, more effective hole injecting materials are aromatic tertiary amine derivatives or phthalocyanine derivatives. Specific examples of the aromatic tertiary amine derivatives include triphenylamine, tritolylamine, tolyldiphenylamine, N,N'-diphenyl-N,N'-(3-methylphenyl)-1,1'-biphenyl-4,4'-diamine, N,N,N',N'-(4-methylphenyl)-1,1'-phenyl-4,4'-diamine, N,N,N',N'(4-methylphenyl)-1,1'-biphenyl-4,4'-diamine, N,N'-diphenyl-N,N'-dinaphthyl-1,1'-biphenyl-4,4'-diamine, N,N'-(methylphenyl)-N,N'-(4-n-butylphenyl)-phenanthrene-9,10-diamine and N,N-bis(4-di-4-tolylaminophenyl)-4-phenyl-cyclohexane, as well as oligomers or polymers having these aromatic tertiary amine skeletons, though not particularly limited thereto. Specific examples of the phthalocyanine (Pc) derivatives include phthalocyanine derivatives and naphthalocyanine derivatives such as $H_2Pc$, CuPc, CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc and GaPc-O-GaPc, though not particularly limited thereto.

Further, the anode of the organic EL device has a function of injecting holes into the hole transporting layer or the light emitting layer, and effectively exhibits a work function of 4.5 eV or higher. Specific examples of the anode material usable in the present invention indium tin oxide (ITO) alloys, tin oxide (NESA), gold, silver, platinum and copper. In addition, the cathode is preferably made of a material having a small work function in order to inject electrons into the electron transporting layer or the light-emitting layer. Specific examples of the cathode material include, but not particularly limited to, indium, aluminum, magnesium, magnesium-indium alloys, magnesium-aluminum alloys, aluminum-lithium alloys, aluminum-scandium-lithium alloys and magnesium-silver alloys.

The respective layers of the organic EL device of the present invention may be formed by conventionally known methods such as vacuum vapor deposition method and spin-coating method without any particular limitation. Specifically, the organic thin film layers used in the organic EL device of the present invention may be produced by known methods such as vacuum vapor deposition method, molecular beam epitaxy (MBE) method, dipping method using a solution prepared by dissolving the respective materials in a solvent, as well as coating methods such as spin-coating method, cast-coating method, bar-coating method and roller-coating method.

The thickness of the respective organic thin film layers in the organic EL device of the present invention is not particularly limited, and is usually in the range of from several nm to 1 μm, since a too small film thickness thereof tends to cause defects such as pin holes, whereas a too large film thickness thereof tends to cause a poor efficiency owing to need of applying a high voltage thereto.

The present invention will be described in more detail by reference to the following examples. However, it should be noted that these examples are only illustrative and not intended to limit the invention thereto.

MEASUREMENT EXAMPLES

The triplet energy, hole mobility and ionization potential of the respective hole transporting materials used in the below-mentioned examples and comparative examples were measured by the following methods. The results are shown in Table 1.

(1) Measurement of Triplet Energy

A minimum excitation triplet energy level Tlwas measured. That is, a phosphorescent spectrum of a sample was measured (10 μmol/L EPA solution (diethyl ether: isopentane: ethanol = 5:5:2 at volume ratio); 77k, quartz cell "FLUOROLOGII" available from SPEX Inc.). A tangent line was drawn against a rise-up portion of the phosphorescent spectrum curve on a short-wavelength side thereof to obtain a wavelength (light emitting end) at an intersection point between the tangent line and an abscissa of the spectrum curve. The thus obtained wavelength was converted into an energy value.

(2) Measurement of Hole Mobility

The hole mobility was measured by a time-of-flight (TOF) method. That is, a hole transporting material as a sample was applied onto an ITO substrate to form thereon a coating film having thickness of 2.5 μm, and a counter electrode made of Al was disposed in an opposed relation thereto. Then, a voltage was applied between both the electrodes at a field intensity of 0.1 to 0.6 MV/cm, and further a $N_2$ laser (pulse width: 2 ns) was irradiated thereto to measure the resultant electric current using a storage oscilloscope (measuring frequency band: 300 MHz). On the basis of the time $\tau$ at which a shoulder of a photoelectric current was generated (photoelectric current decay time) as measured by an ordinary analysis method, the hole mobility was calculated according to the following formula:

$$\mu = d/(\tau E)$$

$\mu$ is a hole mobility; E is a field intensity; and d is a thickness of the film.

(3) Measurement of Ionization Potential

The ionization potential of particles of the respective materials was measured using an atmospheric photoelectron spectrometer "AC-1" available from Riken Keiki Co., Ltd.

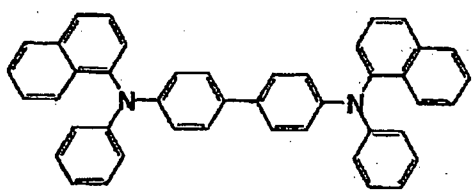

NPD

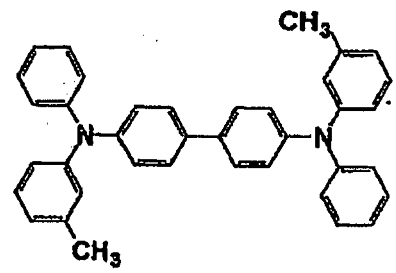

TPD

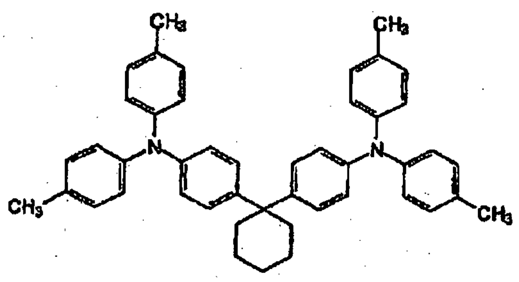

TPAC

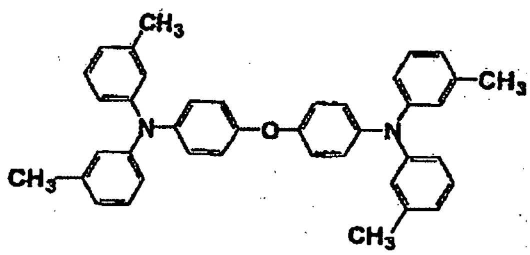

TPAE

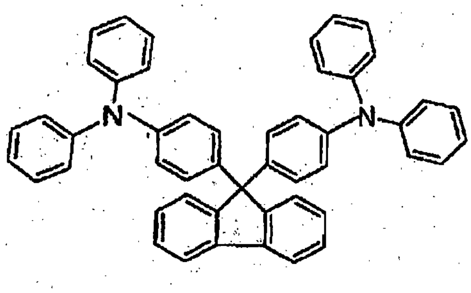

TPDF

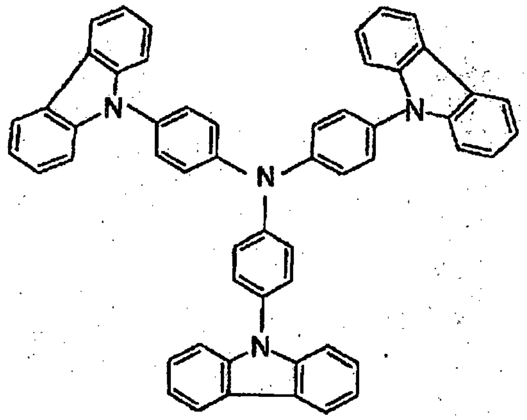

TCTA

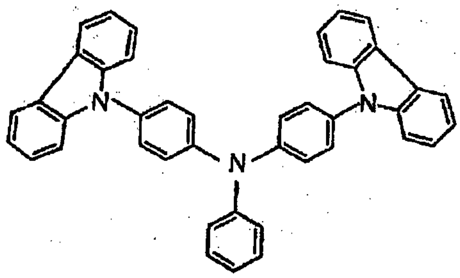

DCTA

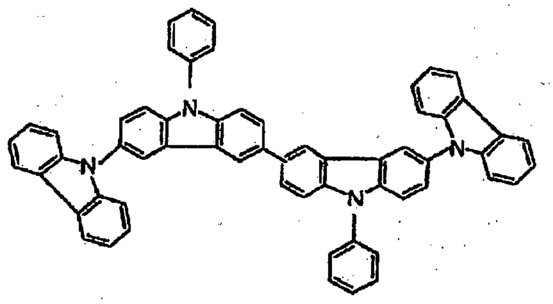

BCBCz

TABLE 1-1

| Measurement Examples | Kind of compound | Light emitting end (nm) | Triplet energy (eV) |
|---|---|---|---|
| 1 | NPD | 504 | 2.46 |
| 2 | TPD | 494 | 2.51 |
| 3 | TPAC | 413 | 3.00 |
| 4 | TPAE | 411 | 3.02 |
| 5 | TPDF | 413 | 3.00 |
| 6 | DCTA | 420 | 2.95 |
| 7 | TCTA | 420 | 2.95 |
| 8 | BCBCz | 432 | 2.82 |

TABLE 1-2

| Measurement Examples | Field intensity ($MV/cm^2$) | Hole mobility ($cm^2/Vs$) | Ionization potential (eV) |
|---|---|---|---|
| 1 | 0.2 | $0.8 \times 10^{-3}$ | 5.4 |
| 2 | 0.2 | $0.9 \times 10^{-3}$ | 5.4 |
| 3 | 0.2 | $1.2 \times 10^{-3}$ | 5.6 |
| 4 | 0.3 | $0.2 \times 10^{-3}$ | 5.5 |

(continued)

| Measurement Examples | Field intensity (MV/cm$^2$) | Hole mobility (cm$^2$/Vs) | Ionization potential (eV) |
|---|---|---|---|
| 5 | 0.3 | 0.8 x $10^{-3}$ | 5.7 |
| 6 | 0.25 | 0.7 x $10^{-3}$ | 5.4 |
| 7 | 0.25 | 0.8 x $10^{-3}$ | 5.4 |
| 8 | 0.3 | 0.3 x $10^{-3}$ | 5.6 |

EXAMPLE 1

A glass substrate with an ITO transparent electrode having a size of 25 mm x 75 mm and a thickness of 1.1 mm which was available from Geomatic Inc., was subjected to ultrasonic cleaning in isopropyl alcohol for 5 minutes, and then subjected to UV ozone cleaning for 30 minutes. The thus cleaned glass substrate with the transparent electrode was attached to a substrate holder of a vacuum deposition apparatus. First, a 10 nm-thick film made of copper phthalocyanine (hereinafter referred to merely as "CuPc film") was formed on a surface of the substrate on which the transparent electrode was provided, so as to cover the transparent electrode. The thus formed CuPc film functioned as a hole injecting layer. Successively, a 30 nm-thick film made of the above TPAC as the hole transporting material was formed on the CuPc film. The thus formed TPAC film functioned as a hole transporting layer. Further, the below-mentioned compound PB102 as a host material was vapor-deposited on the TPAC film to form a 30 nm-thick light emitting layer thereon. Simultaneously with formation of the light emitting layer, the above compound (K-3) as a phosphorescent Ir metal complex was added thereto. The content of the compound (K-3) in the light emitting layer was 7% by weight. The resultant layer functioned as a light emitting layer. Then, a 10 nm-thick film made of (1,1'-bisphenyl)-4-olato) bis(2-methyl-8-quinolinolato) aluminum (film made of the above compound (A-7)) was formed on the light emitting layer. The thus formed A-7 film functioned as an electron injecting layer. Thereafter, Li as a reductive dopant (lithium source available from SAES Getter S.p.A.) and the compound (A-7) were subjected to binary vapor deposition to form a (A-7):Li film as a cathode-side electron injecting layer. Then, a metallic Al was vapor-deposited on the (A-7):Li film to form a metal cathode, thereby producing an organic EL device.

As a result of measuring light emitting characteristics of the thus obtained device, it was confirmed that a bluish green light having a luminance of 93 cd/m$^2$ and a current efficiency of 12.3 cd/A was emitted at a D.C. voltage of 8.4 V. Further, as a result of the measurement of EL spectra, it was confirmed that a light emission peak wavelength was 477 nm, and a light was emitted from the Ir metal complex.

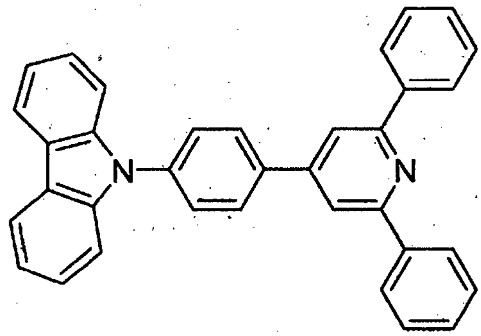

PB102

EXAMPLES 2 TO 5

The same procedure as in EXAMPLE 1 was repeated except for using as the hole transporting material, the respective compounds shown in Table 2 in place of TPAC, thereby producing an organic EL device. The thus produced organic EL device was subjected to measurements of light emission characteristics by the same method as in EXAMPLE 1. The results are shown in Table 2.

COMPARATIVE EXAMPLE 1

The same procedure as in EXAMPLE 1 was repeated except for using as the hole transporting material, NPD in place of TPAC, thereby producing an organic EL device. The thus produced organic EL device was subjected to

measurements of light emission characteristics by the same method as in EXAMPLE 1. The results are shown in Table 2.

As shown in Table 2, it was confirmed that the obtained device exhibited an extremely low current efficiency of 0.75 cd/A. This was because the excitation state generated in the light emitting layer was extinguished. Further, as a result of the measurement of EL spectra, it was confirmed that a light emission peak wavelength was 445 nm, and a light was emitted from not only the Ir metal complex but also NPD as the hole transporting material.

COMPARATIVE EXAMPLE 2

The same procedure as in EXAMPLE 1 was repeated except for using as the hole transporting material, TPD in place of TPAC, thereby producing an organic EL device. The thus produced organic EL device was subjected to measurements of light emission characteristics by the same method as in EXAMPLE 1. The results are shown in Table 2.

As shown in Table 2, it was confirmed that the obtained device exhibited a very low current efficiency of 1.23 cd/A. This was because the excitation state generated in the light emitting layer was extinguished.

TABLE 2-1

| | Hole transporting material | | |
|---|---|---|---|
| | Kind | Triplet energy (eV) | Hole mobility ($cm^2/Vs$) |
| Example 1 | TPAC | 3.00 | $1.2 \times 10^{-3}$ |
| Example 2 | TPDF | 3.00 | $0.8 \times 10^{-3}$ |
| Example 3 | DCTA | 2.95 | $0.7 \times 10^{-3}$ |
| Example 4 | TCTA | 2.73 | $0.8 \times 10^{-3}$ |
| Example 5 | BCBCz | 2.82 | $0.3 \times 10^{-3}$ |
| Comparative Example 1 | NPD | 2.46 | $0.8 \times 10^{-3}$ |
| Comparative Example 2 | TPD | 2.51 | $0.9 \times 10^{-3}$ |

TABLE 2-2

| | Evaluation of characteristics of organic EL device | | | |
|---|---|---|---|---|
| | Voltage (V) | Luminance ($cd/m^2$) | Current efficiency (cd/A) | Color of light emitted |
| Example 1 | 8.4 | 93 | 12.3 | Bluish green |
| Example 2 | 9.5 | 85 | 12.1 | Bluish green |
| Example 3 | 9.2 | 110 | 13.2 | Bluish green |
| Example 4 | 9.0 | 112 | 12.9 | Bluish green |
| Example 5 | 9.1 | 85 | 11.5 | Bluish green |
| Comparative Example 1 | 11.5 | 82 | 0.75 | Blue |
| Comparative Example 2 | 11.8 | 78 | 1.23 | Blue |

As shown in Table 2, it was confirmed that when the triplet energy of the hole transporting material was 2.76 eV or higher, the excitation energy of the Ir metal complex (K-3) as the host material of the light emitting layer was 2.76 eV, and the obtained device was free from deactivation of the excitation state and exhibited an extremely high current efficiency. Meanwhile, the excitation energy of the Ir metal complex was measured by the same method as used for measurement of the triplet energy.

EXAMPLES 6 AND 7 AND COMPARATIVE EXAMPLES 3 AND 4

The same procedure as in EXAMPLE 1 was repeated except for using the respective compounds shown in Table 3 as the hole transporting material, and using the compound (K-10) in place of the compound (K-3) in the light emitting layer, thereby producing an organic EL device. The thus produced organic EL device was subjected to measurements of light emission characteristics by the same method as in EXAMPLE 1. The results are shown in Table 3.

TABLE 3-1

| | Hole transporting material | | |
|---|---|---|---|
| | Kind | Triplet energy (eV) | Hole mobility ($cm^2/Vs$) |
| Example 6 | TPAC | 3.00 | $1.2 \times 10^{-3}$ |
| Example 7 | TPDF | 3.00 | $0.8 \times 10^{-3}$ |
| Comparative Example 3 | NPD | 2.46 | $0.8 \times 10^{-3}$ |
| Comparative Example 4 | TPD | 2.51 | $0.9 \times 10^{-3}$ |

TABLE 3-2

| | Evaluation of characteristics of organic EL device | | | |
|---|---|---|---|---|
| | Voltage (V) | Luminance ($cd/m^2$) | Current efficiency (cd/A) | Color of light emitted |
| Example 6 | 5.8 | 150 | 38.5 | Green |
| Example 7 | 5.7 | 142 | 35.0 | Green |
| Comparative Example 3 | 5.4 | 100 | 22.5 | Green |
| Comparative Example 4 | 5.7 | 106 | 23.5 | Green |

As shown in Table 3, it was confirmed that when the triplet energy of the hole transporting material is 2.55 eV or higher, the excitation energy of the Ir metal complex (K-10) as the host material of the light emitting layer was 2.55 eV, and the obtained device was free from deactivation of the excitation state and exhibited an extremely high current efficiency. Meanwhile, the excitation energy of the Ir metal complex was measured by the same method as used for measurement of the triplet energy.

EXAMPLES 8 TO 10

The same procedure as in EXAMPLE 1 was repeated except for using as the host material of the light emitting layer, the following respective compounds shown in Table 4 in place of PB102, thereby producing an organic EL device. The thus produced organic EL device was subjected to measurements of light emission characteristics by the same method as in EXAMPLE 1. The results are shown in Table 4.

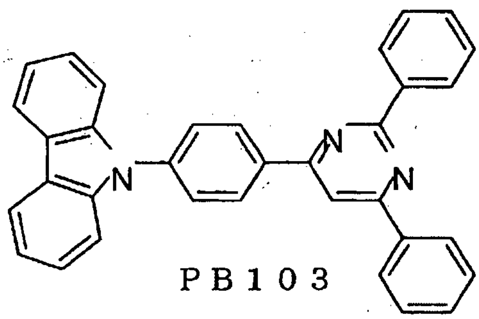

PB103

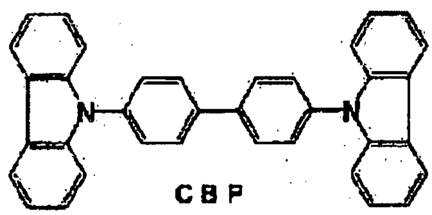

CBP

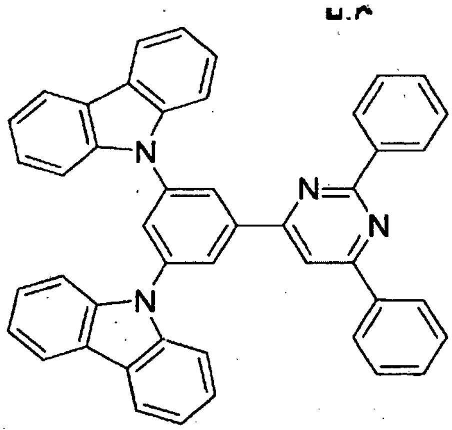

PB115

COMPARATIVE EXAMPLE 5

The same procedure as in COMPARATIVE EXAMPLE 1 was repeated except for using as the host material of the light emitting layer, the compound shown in Table 4 in place of PB102, thereby producing an organic EL device. The thus produced organic EL device was subjected to measurements of light emission characteristics by the same method as in EXAMPLE 1. The results are shown in Table 4.

TABLE 4-1

| | Hole transporting material | | | Light emitting layer | |
|---|---|---|---|---|---|
| | Kind | Triplet energy (eV) | Hole mobility ($cm^2/Vs$) | Kind of host material | Triplet energy (eV) |
| Example 8 | TPAC | 3.00 | $1.2 \times 10^{-3}$ | PB103 | 2.82 |
| Example 9 | TPAC | 3.00 | $1.2 \times 10^{-3}$ | PB115 | 2.90 |
| Example 10 | TPAC | 3.00 | $1.2 \times 10^{-3}$ | CBP | 2.81 |
| Comparative Example 5 | NPD | 2.46 | $0.8 \times 10^{-3}$ | CBP | 2.81 |

TABLE 4-2

| | Evaluation of characteristics of organic EL device | | | |
|---|---|---|---|---|
| | Voltage (V) | Luminance ($cd/m^2$) | Current efficiency (cd/A) | Color of light emitted |
| Example 8 | 5.8 | 150 | 39.5 | Green |
| Example 9 | 5.7 | 142 | 36.0 | Green |
| Example 10 | 5.1 | 102 | 22.6 | Green |
| Comparative Example 5 | 4.9 | 98 | 15.0 | Green |

As shown in Table 4, from the comparison between the results of Example 10 and the results of Examples 8 and 9, it was confirmed that when the material containing pyridine or pyridinoimidazole as an electron-deficient ring was used as the host material of the light emitting layer, the obtained device exhibited a very high current efficiency. This was because the host materials used in Examples 8 and 9 were an electron transporting material, so that electrons and holes were recombined with each other at an interface between the host material and the hole transporting layer, and the excitation state generated in the host material was free from deactivation due to the hole transporting material.

COMPARATIVE EXAMPLE 6

A glass substrate with an ITO transparent electrode having a size of 25 mm x 75 mm and a thickness of 1.1 mm which was available from Geomatic Inc., was subjected to ultrasonic cleaning in isopropyl alcohol for 5 minutes, and then subjected to UV ozone cleaning for 30 minutes. The thus cleaned glass substrate with the transparent electrode was attached to a substrate holder of a vacuum deposition apparatus. First, a 10 nm-thick CuPc film was formed on a surface of the substrate on which the transparent electrode was provided, so as to cover the transparent electrode. The thus formed CuPc film functioned as a hole injecting layer. The substrate was taken out of the holder, and a coating solution prepared by dissolving polyvinyl carbazole (Mw = 63000; available from Aldrich Inc.; hole mobility: 2 x $10^{-7}$ $cm^2/Vs$) as a hole transporting material and tris(2-phenylpyridine)iridium complex as an ortho-metallized complex at a mass ratio of 40:1 in dichloromethane, was applied onto the thus formed hole injecting layer using a spin coater, and then dried at room temperature to thereby form a 40 nm-thick hole transporting layer. Thereafter, the substrate having the thus formed hole transporting layer was further dried under heating at 150°C for one hour to remove the solvent therefrom. The substrate was attached again to the substrate holder of the vacuum deposition apparatus, and then the above compound PB102 was vapor-deposited on the hole transporting layer to form a 30 nm-thick light emitting layer thereon. Simultaneously with formation of the light emitting layer, the above compound (K-3) as a phosphorescent Ir metal complex was added thereto. The content of the compound (K-3) in the light emitting layer was 7% by weight. The resultant film functioned as a light emitting layer. Then, a 10 nm-thick film made of the above compound (A-7) was formed on the light emitting layer. The thus formed A-7 film functioned as an electron injecting layer. Thereafter, Li as a reductive dopant (lithium source available from SAES Getter S.p.A.) and the compound (A-7) were subjected to binary vapor deposition to form a (A-7):Li film as a cathode-side electron injecting layer. Then, a metallic Al was vapor-deposited on the (A-7):Li film to form a metal cathode, thereby producing an organic EL device.

As a result of measuring light emitting characteristics of the thus obtained device, it was confirmed that a bluish green light was emitted at a D.C. voltage of 8.4 V, and had a luminance of 83 $cd/m^2$ and a current efficiency of 7.8 cd/A. Thus, the organic EL device using as the material of the hole transporting layer, polyvinyl carbazole whose hole mobility was as low as 2 x $10^{-7}$ $cm^2/Vs$, required application of a considerably high driving voltage. Further, in addition to the above high driving voltage, the obtained organic EL device was also deteriorated in current efficiency as compared to those obtained in Examples. Accordingly, it was recognized that when the hole mobility became low, especially the current efficiency was largely affected by the low hole mobility.

INDUSTRIAL APPLICABILITY

In the organic electroluminescence device of the present invention, the hole transporting material constituting the hole transporting layer has a triplet energy of 2.52 to 3.70 eV and a hole mobility of $10^{-6}$ $cm^2/Vs$ or higher as measured at a field intensity of 0.1 to 0.6 MV/cm. Therefore, the organic electroluminescence device can emit a phosphorescent light at a favorable current efficiency and has a long lifetime and, therefore, is useful as an organic electroluminescence device for full color display.

## Claims

1. An organic electroluminescence device, comprising a cathode, an anode and sandwiched between the cathode and the anode, at least a hole transporting layer and a light emitting layer containing a phosphorescent light emitting material and an electron transporting host material, wherein
the hole transporting layer comprises a hole transporting material having a triplet energy of 2.52 to 3.70 eV and a hole mobility of $10^{-6}$ $cm^2/Vs$ or higher as measured at a field intensity of 0.1 to 0.6 MV/cm, and
the host material contained in the light emitting layer is represented by the following formula (5) or (6):

$$(Cz\text{-})_m A \qquad (5)$$

$$Cz\text{-}A_n \qquad (6)$$

wherein Cz represents a substituted or unsubstituted carbazolyl group or a substituted or unsubstituted azacarbazolyl group,
A represents an aryl-substituted nitrogen-containing ring group, a diaryl-substituted nitrogen-containing ring group or a triaryl-substituted nitrogen-containing ring group, wherein the nitrogen-containing ring is selected from the group consisting of imidazole, benzimidazole, triazole, tetrazole, oxadiazole, thiadiazole, oxatriazole, thiatriazole, triazine, quinoxaline, quinoline, benzopyrimidine, pyridine, pyrazine, pyrimidine, and imidazopyridine,

m is an integer of 1 to 3, and
n is an integer of 1 to 3,
provided that the following configurations for an electroluminescent device with a layered structure are excluded:

ITO/CuPc/TPAC/PB102+K-3/Alq/Alq+Li/Al,
ITO/CuPc/TPAC/PB115+K-3/Alq/Alq+Li/Al,
ITO/CuPc/TPAC/PB102+K-3/BAlq+Li/Al,
ITO/TPAC/PB115+K-10/Alq/Alq+Li/Al,
ITO/CuPc/TCTA/PB115+K-23/A-7/Alq+Li/Al, and
ITO/CuPc/TCTA/PB115+K-23/C-15/Alq+Li/Al,

wherein
ITO is indium-tin-oxide,
CuPc is copper phthalocyanine,
TPAC is represented by the following formula:

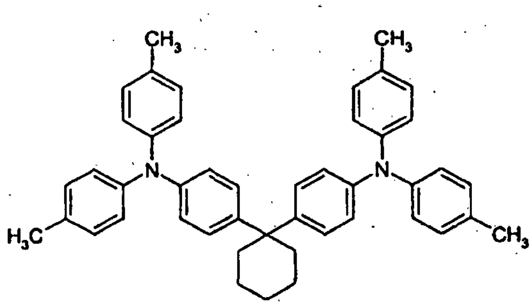

TCTA is represented by the following formula:

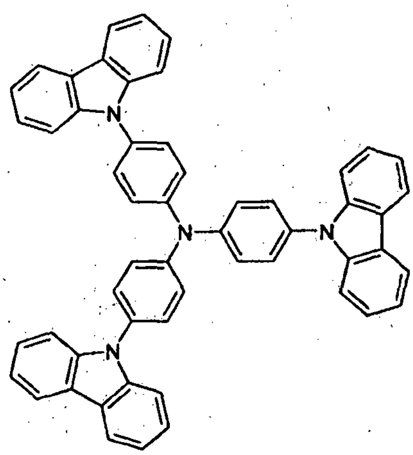

PB102 is represented by the following formula:

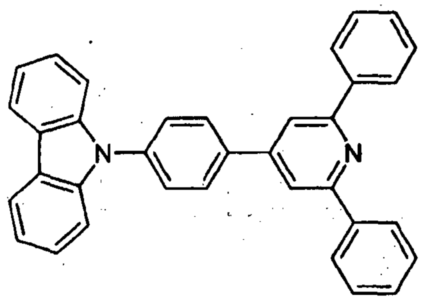

PB115 is represented by the following formula:

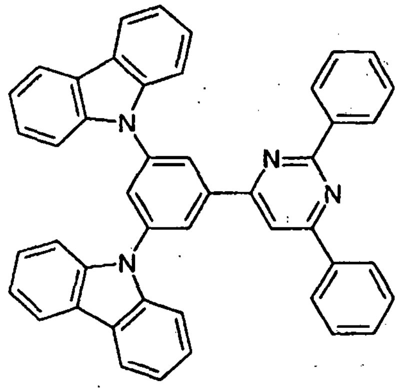

K-3 is represented by the following formula:

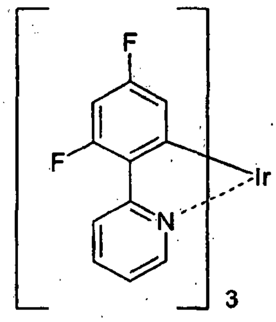

K-10 is represented by the following formula:

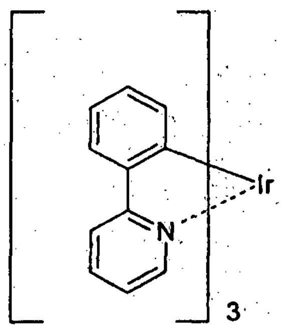

K-23 is represented by the following formula:

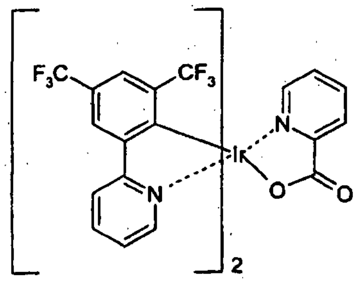

Alq is represented by the following formula:

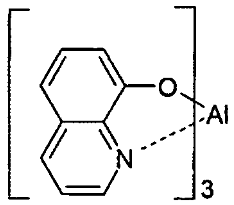

BAlq is represented by the following formula:

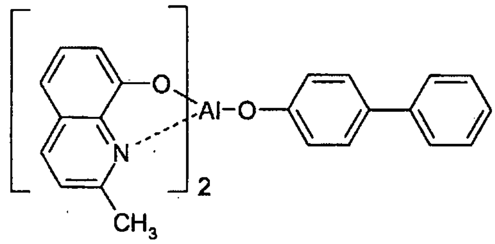

A-7 is represented by the following formula:

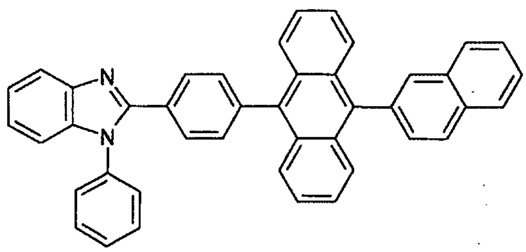

and

C-15 is represented by the following formula:

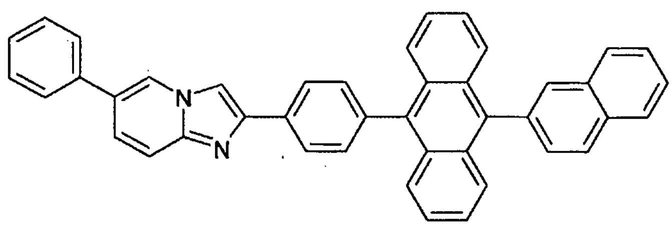

2. The organic electroluminescence device according to claim 1, wherein the nitrogen-containing ring group is selected from the group consisting of pyridine, quinoline, pyrazine, pyrimidine, quinoxaline, triazine, imidazole, and imidazopyridine.

3. The organic electroluminescence device according to claim 1, wherein the hole transporting material has an ionization potential of 5.8 eV or lower.

4. The organic electroluminescence device according to claim 1, wherein the hole transporting material has a triplet energy of 2.76 to 3.70 eV.

5. The organic electroluminescence device according to claim 1, wherein the host material contained in the light emitting layer has a triplet energy of 2.52 eV or higher.

6. The organic electroluminescence device according to claim 1, wherein a zone where electrons and holes recombine with each other or a light emitting zone is provided at an interface between the light emitting layer and the hole transporting layer.

7. The organic electroluminescence device according to claim 1, wherein a layer adjacent to the cathode contains a reductive dopant.

**Patentansprüche**

1. Organische Elektrolumineszenzvorrichtung, umfassend eine Kathode, eine Anode und zwischen der Kathode und der Anode mindestens eine Lochleitungsschicht und eine Licht-emittierende Schicht, die einen phosphoreszierenden Licht-emittierenden Stoff und ein elektronentransportierendes Trägermaterial enthält, worin die Lochleitungsschicht ein Lochleitungsmaterial mit einer Triplet-Energie von 2,52 bis 3,70 eV und einer Lochmobilität von $10^{-6}$ $cm^2/Vs$ oder höher gemessen bei einer Feldstärke von 0,1 bis 0,6 MV/cm umfasst, und
das Trägermaterial, welches in der Licht-emittierenden Schicht enthalten ist, durch die folgende Formel (5) oder (6) dargestellt wird:

$$(Cz-)_mA \qquad (5)$$

$$Cz-A_n \qquad (6)$$

worin Cz eine substituierte oder unsubstituierte Carbazolylgruppe oder eine substituierte oder unsubstituierte Azacarbazolylgruppe ist,
A ein Aryl-substituierter Stickstoff-enthaltender Ring, ein Diaryl-substituierter Stickstoff-enthaltender Ring oder ein Triaryl-substituierter Stickstoff-enthaltender Ring ist, worin der Stickstoff-enthaltende Ring ausgewählt ist aus der Gruppe, bestehend aus Imidazol, Benzimidazol, Triazol, Tetrazol, Oxadiazol, Thiadiazol, Oxatriaziol, Thiatriazol, Triazin, Chinoxalin, Chinolin, Benzopyrimidin, Pyridin, Pyrazin, Pyrimidin und Imidazopyridin,
m ist eine ganze Zahl von 1 bis 3, und
n ist eine ganze Zahl von 1 bis 3,
unter der Voraussetzung, dass die folgenden Konfigurationen einer Elektrolumineszvorrichtung mit Schichtstruktur ausgeschlossen sind:

ITO/CuPc/TPAC/PB102+K-3/Alq/Alq+Li/Al,
ITO/CuPc/TPAC/PB115+K-3/Alq/Alq+Li/Al,
ITO/CuPc/TPAC/PB102+K-3/BAlq+Li/Al,
ITO /TPAC/PB115+K-10/Alq/Alq+Li/Al,
ITO/CuPc/TCTA/PB115+K-23/A-7/Alq+Li/Al, und
ITO/CuPc/TCTA/PB115+K-23/C-15/Alq+Li/Al,

worin
ITO Indiumzinnoxid ist,
CuPc Kupferphthalocyanin ist,
TPAC durch die folgende Formel dargestellt ist:

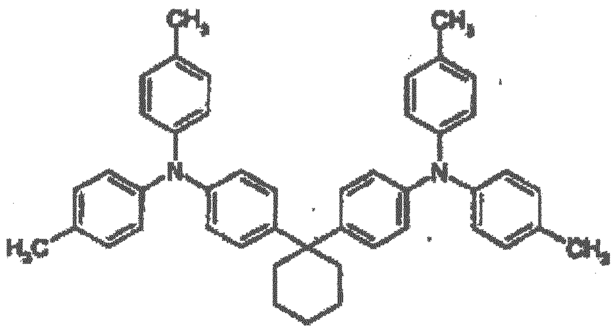

TCTA durch die folgende Formel dargestellt ist:

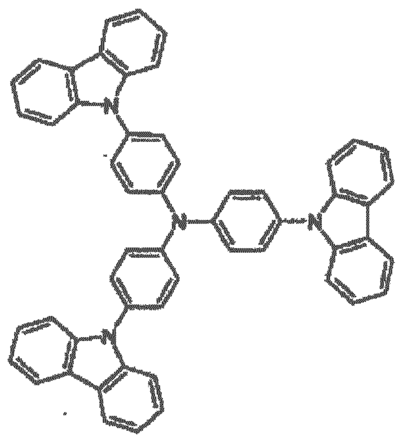

PB102 durch die folgende Formel dargestellt ist:

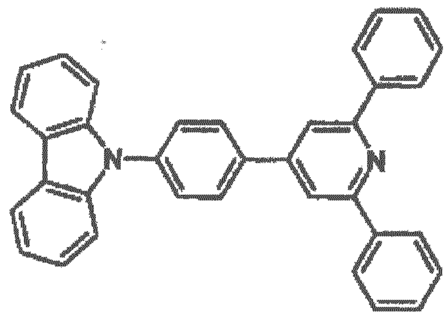

PB115 durch die folgende Formel dargestellt ist:

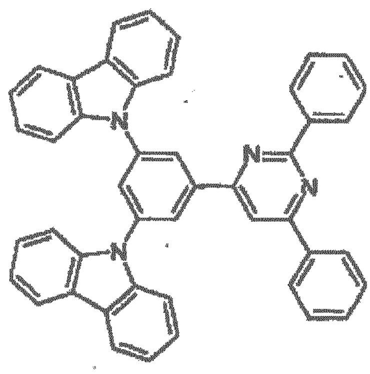

K-3 durch die folgende Formel dargestellt ist:

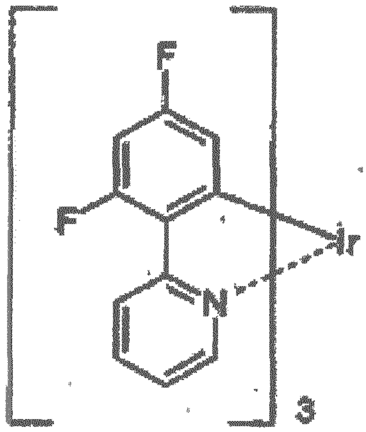

K-10 durch die folgende Formel dargestellt ist:

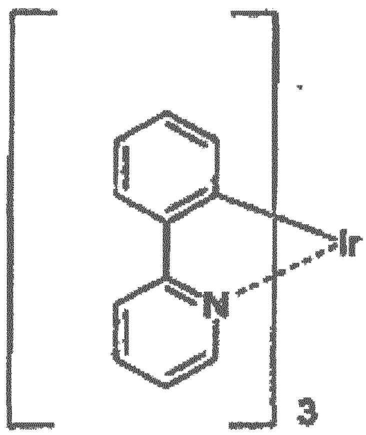

K-23 durch die folgende Formel dargestellt ist:

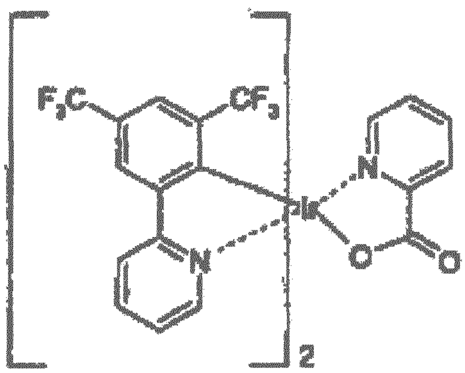

Alq durch die folgende Formel dargestellt wird:

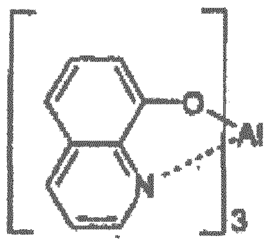

BAlq durch die folgende Formel dargestellt wird:

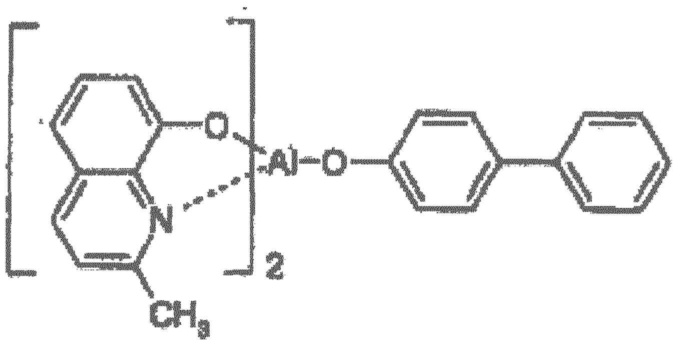

A-7 durch die folgende Formel dargestellt wird:

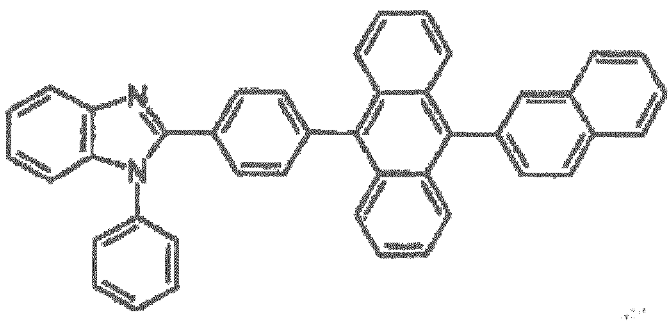

und
C-15 durch die folgende Formel dargestellt ist:

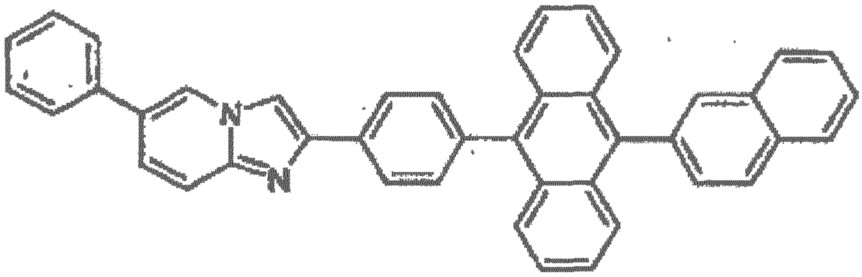

2. Die organische Elektrolumineszenzvorrichtung nach Anspruch 1, worin der Stickstoffenthaltende Ring ausgewählt ist aus der Gruppe, bestehend aus Pyridin, Chinolin, Pyrazin, Pyrimidin, Chinoxalin, Triazin, Imidazol und Imidazopyridin,

3. Die organische Elektrolumineszenzvorrichtung nach Anspruch 1, worin das Lochleitungsmaterial ein Ionisierungspotential von 5,8 eV oder weniger aufweist.

4. Die organische Elektrolumineszenzvorrichtung nach Anspruch 1, worin das Lochleitungsmaterial eine Triplet-Energie von 2,76 bis 3,70 eV aufweist.

5. Die organische Elektrolumineszenzvorrichtung nach Anspruch 1, worin das Trägermaterial, welches in der Licht-emittierenden Schicht enthalten ist, eine Triplet-Energie von 2.52 eV oder höher aufweist.

6. Die organische Elektrolumineszenzvorrichtung nach Anspruch 1, worin eine Zone, in der Elektronen und Löcher miteinander rekombinieren, oder eine Licht-emittierende Zone an der Grenzfläche zwischen Licht-emittierender Schicht und der Lochleitungsschicht angeordnet ist.

7. Die organische Elektrolumineszenzvorrichtung nach Anspruch 1, worin eine an der Kathode anliegende Schicht einen reduzierenden Dotierstoff enthält.

## Revendications

1. Dispositif électroluminescent organique comprenant une cathode, une anode et situé entre le cathode et l'anode au moins une couche de transport de trous et une couche émettant de la lumière contenant un matériau phosphorescent émettant de la lumière et un matériau hôte de transport d'électrons, dans lequel
la couche de transport des trous comprend un matériau de transport de trous ayant une énergie triplet de 2,52 à 3,70 eV et une mobilité des trous de $10^{-6}$ $cm^2/Vs$ ou plus élevée tel que mesurée à une intensité de champs de 0,1 à 0,6 MV/cm, et
le matériau hôte contenu dans la couche émettant de la lumière est représenté par la formule (5) ou (6) suivante :

$$(Cz-)_mA \quad (5)$$

$$Cz-A_n \quad (6)$$

dans laquelle Cz représente un groupe carbazolyle substitué ou non-substitué ou un groupe azacarbazolyle substitué ou non-substitué,
A représente un groupe annulaire aryle-substitué contenant de l'azote, un groupe annulaire diaryle-substitué contenant de l'azote ou un groupe annulaire triaryle-substitué contenant de l'azote, dans lequel l'anneau contenant de l'azote est sélectionné parmi le groupe consistant en l'imidazole, le benzimidazole, le triazole, le tétrazole, l'oxadiazole, le thiadiazole, l'oxatriazole, le thiatriazole, la triazine, la quinoxaline, la quinoléine, la benzopyrimidine, la pyridine, la pyrazine, la pyrimidine et l'imidazopyridine,
m est un nombre entier de 1 à 3, et
n est un nombre entier de 1 à 3,
à condition que les configurations suivantes pour un dispositif électroluminescent avec une structure en couches sont exclues :

ITO/CuPc/TPAC/PB102+K-3/Alq/Alq+Li/Al,
ITO/CuPc/TPAC/PB115+K-3/Alq/Alq+Li/Al,
ITO/CuPc/TPAC/PB102+K-3/BAlq+Li/VAl,
ITO/TPAC/PB115+K-10/Alq/Alq+Li/Al,
ITO/CuPc/TCTA/PB115+K-23/A-7/Alq+Li/Al, et
ITO/CuPc/TCTA/PB115+K-23/C-15/Alq+Li/Al,

dans lesquelles
ITO est l'oxyde d'indium-étain
CuPc est la phtalocyanine de cuivre,
TPAC est représenté par la formule suivante :

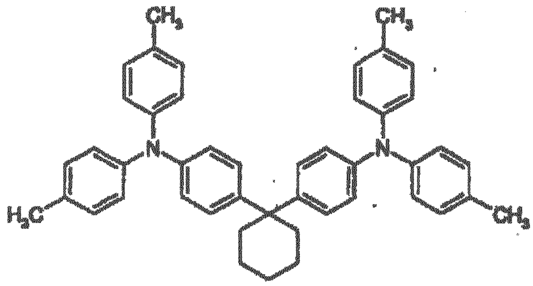

TCTA est représenté par la formule suivante :

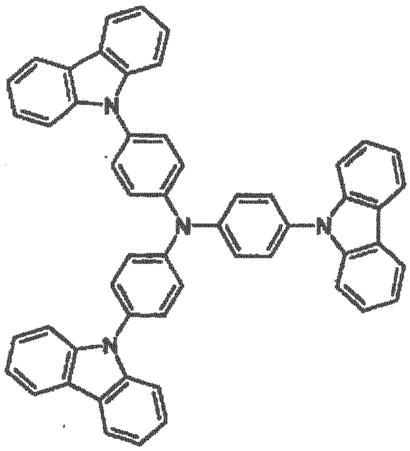

PB102 est représenté par la formule suivante :

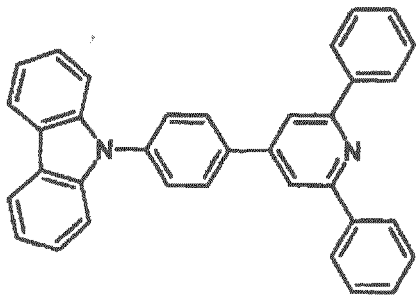

PB115 est représenté par la formule suivante :

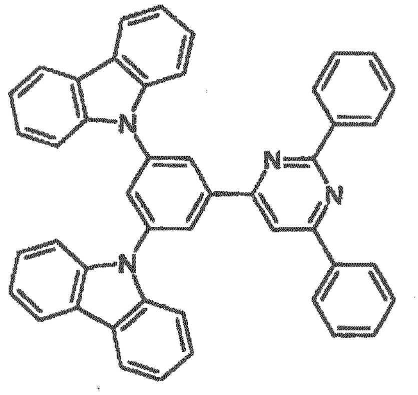

K-3 est représenté par la formule suivante :

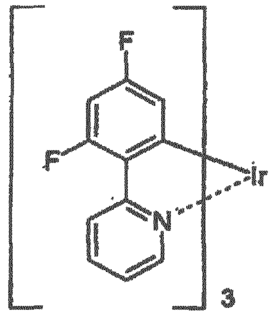

K-10 est représenté par la formule suivante :

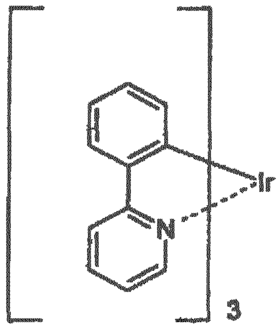

K-23 est représenté par la formule suivante :

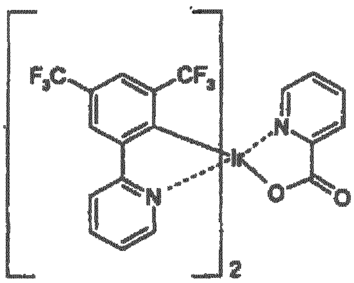

Alq est représenté par la formule suivante :

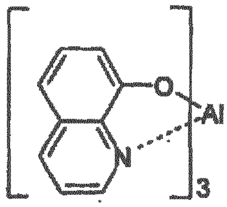

BAlq est représenté par la formule suivante :

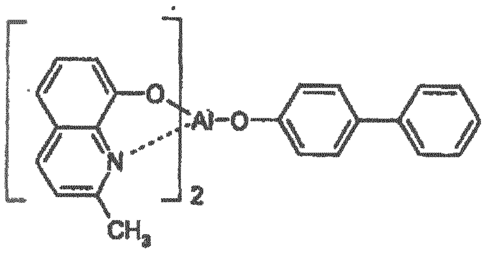

A-7 est représenté par la formule suivante :

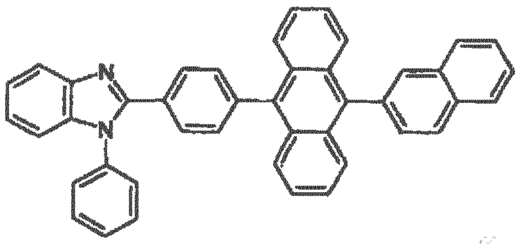

et
C-15 est représenté par la formule suivante :

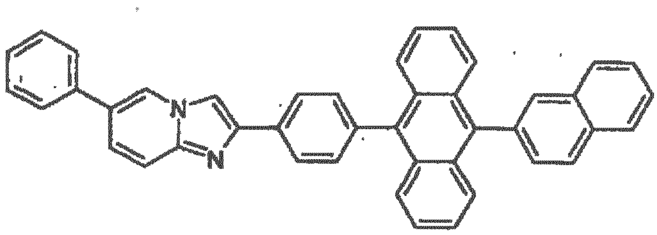

2. Dispositif électroluminescent organique selon la revendication 1, dans lequel le groupe annulaire contenant d'azote est sélectionné parmi le groupe consistant en la pyridine, la quinoléine, la pyrazine, la pyrimidine, la quinoxaline, la triazine, l'imidazole, et l'imidazopyridine.

3. Dispositif électroluminescent organique selon la revendication 1, dans lequel le matériau de transport de trous a un potentiel d'ionisation de 5,8 eV ou moins.

4. Dispositif électroluminescent organique selon la revendication 1, dans lequel le matériau de transport de trous a une énergie triplet de 2,76 à 3,70 eV.

5. Dispositif électroluminescent organique selon la revendication 1, dans lequel le matériau hôte contenu dans la couche émettant de la lumière a une énergie triplet de 2,52 eV ou plus élevée.

6. Dispositif électroluminescent organique selon la revendication 1, dans lequel une zone, où des électrons et des

trous recombinent l'un avec l'autre ou une zone émettant de la lumière est prévue à une interface entre la couche émettant de la lumière et la couche de transport de trous.

**7.** Dispositif électroluminescent organique selon la revendication 1, dans lequel une couche adjacente à la cathode contient un dopant réducteur.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP HEISEI81996239655 B
- JP HEISEI71995138561 B
- JP HEISEI31991200289 B
- US 6097147 A
- WO 0141512 A
- EP 1551206 A1
- US 20020028329 A1
- US 20020045061 A1
- US 2009019427 A1


### Non-patent literature cited in the description


- **SINCE C. W. TANG et al.** Eastman Kodak Company have reported organic EL devices of a laminate type driven at a low electric voltage. *Applied Physics Letters,* 1987, vol. 51, 913
- **D.F. O'BRIEN ; M.A. BALDO et al.** Improved Energy Transfer in Electrophosphorescent Devices. *Applied Physics Letters,* 18 January 1999, vol. 74 (3), 442-444
- **M.A. BALDO et al.** Very High-Efficiency Green Orange Light-Emitting Devices based on Electrophosphorescence. *Applied Physics Letters,* 05 July 1999, vol. 75 (1), 4-6
- **X. ZHOU et al.** *Applied Physics Letters,* 2002, vol. 81 (21), 4070-4072
- *Synthetic Metals,* 2000, 331
- Electrical Transport in Solids. Pergamon Press, 1981, 346-348